# EUROPEAN PATENT APPLICATION

(11) **EP 4 831 667 A1**
(43) Date of publication of application: **28.10.2026**
(21) Application number: 26162895.2
(22) Date of filing: 06.03.2026
(51) Int. Cl.: G01R 33/00, G01D 5/244, G01P 3/489, G01P 3/487

(54) **SYSTEMS AND METHODS FOR OFFSET DETECTION AND COMPENSATION**

(30) Priority: 21.04.2025 US 202519184219
(71) Applicant: Allegro MicroSystems, LLC, Manchester, NH 03103-3353 (US)
(72) Inventor: BILARDI, Mattia, 20124 Milano (IT); AMOROSO, Giuseppe Luca, 92027 Licata (IT); ERRASTI, Bruno Giulian, C1416DPB Buenos Aires (AR)
(74) Representative: South, Nicholas Geoffrey

(57) **Abstract**

Disclosed are example systems and methods for detecting and compensating for an offset in a signal, such as a signal received from a sensor device. In particular, described are example systems and methods for detecting and compensating for an offset, such as a current offset, in a square wave signal. An offset in a signal received from a sensor device may occur, for example, when a resistive short exists somewhere in a circuit coupling the signal output from the sensor device to components that detect a level (or value) of the signal output from the sensor device. Using systems and methods disclosed herein, such an offset may be detected, and the signal can be compensated, such that the signal can be accurately detected and interpreted.

## Description

### BACKGROUND

Sensor devices are often used to monitor parameters of a system. For example, sensor devices may be used to measure speed and/or direction of rotation of a rotation object, such as of a wheel. The speed and/or direction measurements may then be used, such as in the implementation of driver assistance applications.

Some sensors monitor properties by detecting a magnetic field associated with proximity or movement of a target with respect to one or more magnetic field sensing elements. One such magnetic field sensor is the Allegro MicroSystems A19360 High-Resolution GMR Wheel Speed and Distance Sensor Integrated Circuit (IC). Channel output, or speed signals, can be provided in the form of a square wave with pulses having a frequency indicative of the speed of rotation of the target. Additional pulses can include additional information, such as a direction of a rotation of the target.

Numerous applications, spanning from industrial automation and robotics, to self-parking, braking, and power steering applications in automobiles, may require monitoring of a rotation speed and direction of a rotating object. Numerous applications may also require interpretation of pulses of a square wave signal.

### SUMMARY

Disclosed are example systems and methods for detecting and compensating for an offset in a signal, such as a signal received from a sensor device. In particular, described are example systems and methods for detecting and compensating for an offset, such as a current offset, in a square wave signal. An offset in a signal received from a sensor device may occur, for example, when a resistive short exists somewhere in a circuit coupling the signal output from the sensor device to components that detect a level (or value) of the signal output from the sensor device. Using systems and methods disclosed herein, such an offset may be detected, and the signal can be compensated, such that the signal can be accurately detected and interpreted.

In accordance with some embodiments, there is provided a system. The system comprises an analog-to-digital converter and circuitry. The analog-to-digital converter is configured to receive an analog square wave signal, and output a digital signal representing the analog square wave signal. The circuitry is configured to identify a transition in the digital signal to a base current level, sample the base current level of the digital signal, and determine an amount of offset current based on a difference between the sampled base current level and a predetermined current level.

In some embodiments, the analog square wave signal is received from a sensor device.

In some embodiments, the circuitry is further configured to adjust the digital signal by the amount of the offset current, and output the adjusted digital signal.

In further embodiments, the circuitry is further configured to output information about the determined amount of the offset current.

In still further embodiments, the circuitry is further configured to delay the digital signal, compare a level of the delayed digital signal with a level of the digital signal to identify the transition, and sample the base current level of the digital signal by sampling the base current level of the delayed digital signal.

In some embodiments, the transition corresponds to a falling edge of the digital signal.

In further embodiments, the transition is a first transition, and the circuitry is further configured to start sampling a current level of the delayed digital signal after the first transition has been identified, and stop sampling the current level of the delayed digital signal when a second transition has been identified, the second transition corresponding to a rising edge of the digital signal.

In still further embodiments, the circuitry comprises a filter configured to filter the sampled based current level, wherein the sampled base current level used in determining the amount of offset current is the filtered sampled base current level.

In some embodiments, the filter is a finite impulse response (FIR) filter.

In some embodiments, the analog square wave signal is a square wave with three current levels.

In further embodiments, the analog square wave is an AK protocol signal.

In still further embodiments, the analog square wave signal is a square wave with two current levels.

In some embodiments, the system further comprises a memory storing instructions, wherein the circuitry comprises a processor that, when executing the instructions, is configured to identify the transition in the digital signal, sample the base current level, and determine the amount of offset current.

In further embodiments, the analog square wave signal comprises a current offset due to a resistive short.

In still further embodiments, the analog square wave signal comprises three different current levels.

In some embodiments, the sensor device is a magnetic wheel speed sensor device.

In further embodiments, the system is implemented in a power management integrated circuit (PMIC).

In still further embodiments, the circuitry is further configured to be programmed to trim the determined amount of offset current.

In some embodiments, the circuitry further comprises hysteresis circuitry, the hysteresis circuitry receiving the adjusted digital signal and identifying that the adjusted digital signal corresponds to one of at least two different current levels.

Furthermore, in accordance with some embodiments, there is provided a method. The method comprises identifying a transition in a digital signal to a base current level, sampling the base current level of the digital signal, and determining an amount of offset current based on a difference between the sampled base current level and a predetermined current level.

In some embodiments, the method further comprises adjusting the digital signal by the amount of the offset current, and outputting the adjusted digital signal.

In further embodiments, the method further comprises outputting information about the determined amount of the offset current.

In still further embodiments, the transition is a first transition corresponding to a falling edge of the digital signal, and the method further comprises delaying the digital signal, comparing the delayed digital signal with the digital signal to identify the first transition, sampling the base current level of the digital signal by sampling a current level of the delayed digital signal after the first transition has been identified, and stopping sampling of the current level of the delayed digital signal when a second transition has been identified, the second transition corresponding to a rising edge of the digital signal.

Before explaining example embodiments consistent with the present disclosure in detail, it is to be understood that the disclosure is not limited in its application to the details of constructions and to the arrangements set forth in the following description or illustrated in the drawings. The disclosure is capable of being practiced and carried out in various ways. Also, it is to be understood that the phraseology and terminology employed herein, as well as in the abstract, are for the purpose of description and should not be regarded as limiting.

It is to be understood that both the foregoing general description and the following detailed description are explanatory only and are not restrictive of the claimed subject matter.

### BRIEF DESCRIPTION OF THE DRAWINGS

The accompanying drawings are incorporated in and constitute part of this specification. The drawings, together with the description, illustrate and serve to explain the principles of various example embodiments of the disclosure.
FIG. 1 shows a diagram of an example system for sensing a magnetic field.
FIG. 2A shows an example system, including a sensor device and a magnetic target.
FIG. 2B shows another example system, including a sensor device and a target.
FIG. 3 shows an example system including a sensor device and a target, a plot showing an example magnetic profile of the target as it rotates, a plot showing an example differential analog signal of a channel of the sensor device, a plot showing a detected switching of the channel by the sensor device, and a plot showing example output events of the sensor device.
FIG. 4A shows a plot of example output current pulses that convey information about a target.
FIG. 4B shows another plot of example output current pulses that convey information about a target.
FIG. 4C shows a plot of example sets of output current pulses that convey information about a target.
FIG. 5A shows an example system including a sensor device and a controller.
FIG. 5B shows another example system including a sensor device and a controller.
FIG. 5C shows still another example system including a sensor device and a controller.
FIG. 6A shows a circuit diagram illustrating an example location of a resistive short coupled between a ground terminal and a high side terminal of a sensor device.
FIG. 6B shows a circuit diagram illustrating an example location of a resistive short coupled between a battery terminal and a high side terminal of a sensor device.
FIG. 6C shows a circuit diagram illustrating an example location of a resistive short coupled between a battery terminal and a low side terminal of a sensor device.
FIG. 6D shows a circuit diagram illustrating an example location of a resistive short coupled between a ground terminal and a low side terminal of a sensor device.
FIG. 7 shows a diagram of an example system including a sensor device and a controller with a current offset compensation system.
FIG. 8 shows a diagram of another example system including a sensor device and a controller with a current offset compensation system.
FIG. 9 shows a diagram of an example system for detecting and compensating for an offset of an output received from a sensor device.
FIG. 10 shows a diagram of another example simulation of a system for detecting and compensating for an offset of an output received from a sensor device.
FIG. 11A shows a plot of an example simulated output of an analog-to-digital converter that has converted an analog square wave signal received from a sensor device.
FIG. 11B shows a plot of an example simulated gated clock output, the clock output being gated to only cause current of a square wave signal to be sampled after a falling transition of the square wave signal and to not sample a current of the square wave signal after a rising transition of the square wave signal.
FIG. 11C shows a plot of an example simulated sampled current from a square wave signal.
FIG. 11D shows a plot of an example simulated adjusted square wave signal that has been compensated for an offset of the square wave signal received from the sensor device.
FIG. 12 shows plots of a simulated output of an analog-to-digital converter that has converted an analog square wave signal received from a sensor device to a digital square wave signal, a simulated enable input for enabling sampling of current of the digital square wave signal, a simulated sampled current of the digital square wave, a simulated determined offset current of the digital square wave, and a simulated adjusted digital square wave signal that has been compensated for an offset of the square wave signal received from the sensor device.
FIG. 13 shows a block diagram of an example system for detecting and compensating for an offset of a signal received from a sensor device, with inputs and output of the example system shown.
FIG. 14 shows an example process for detecting and compensating for an offset of a signal received from a sensor device.
FIG. 15 shows an example networked environment.
FIG. 16 shows an example computing device.

The drawings are not necessarily to scale, or inclusive of all elements of a system, emphasis instead generally being placed upon illustrating the concepts, structures, and techniques sought to be protected herein.

### DETAILED DESCRIPTION

Reference will now be made in detail to the embodiments of the disclosure, certain examples of which are illustrated in the accompanying drawings.

In the following description, numerous specific details are set forth regarding the systems and methods of the disclosed subject matter, and the environment in which such systems and methods operate, to provide a thorough understanding of the disclosed subject matter. After reading the descriptions provided herein, it will be apparent to one skilled in the art, however, that the disclosed subject matter may be practiced without such specific details. It will also be apparent to one skilled in the art that certain features, which are well known within the art, are not described in detail to avoid unnecessary complication of the description of the systems and methods described herein. In addition, it will be understood that the embodiments provided below are examples, and that it is contemplated that there are other systems and methods that are within the scope of the subject matter disclosed herein.

Disclosed are example systems and methods for detecting and compensating for an offset in a signal, such as a signal received from a sensor device. In particular, described are example systems and methods for detecting and compensating for an offset, such as a current offset, in a square wave signal. An offset in a signal received from a sensor device may occur, for example, when a resistive short exists somewhere in a circuit coupling the signal output from the sensor device to components that detect a level (or value) of the signal output from the sensor device. Using systems and methods disclosed herein, such an offset may be detected, and the signal can be compensated, such that the signal can be accurately detected and interpreted.

Sensor devices are often used to monitor parameters of a system. For example, sensor devices may be used to measure speed and/or direction of rotation of a rotation object, such as of a wheel. The speed and/or direction measurements may then be used, such as in the implementation of driver assistance applications.

Some sensors monitor properties by detecting a magnetic field associated with proximity or movement of a target with respect to one or more magnetic field sensing elements. One such magnetic field sensor is the Allegro MicroSystems A19360 High-Resolution GMR Wheel Speed and Distance Sensor Integrated Circuit (IC). Channel output, or speed signals, can be provided in the form of a square wave with pulses having a frequency indicative of the speed of rotation of the target. Additional pulses can include additional information, such as a direction of a rotation of the target.

Numerous applications, spanning from industrial automation and robotics, to self-parking, braking, and power steering applications in automobiles, may require monitoring of a rotation speed and direction of a rotating object. Numerous applications may also require interpretation of pulses of a square wave signal.

A magnetic field sensor device may be used to determine a speed and/or direction of rotation of a rotation object. With a magnetic field sensor device, one or more magnetic field sensing elements of the sensor device that are responsive to a magnetic field may be positioned near a rotation object and may detect a magnetic field associated with the rotation object.

An object (e.g., rotating object) monitored by a sensor device is often referred to as a target. Accordingly, an object whose characteristics are sensed by the sensor device may be referred to as a "target" herein.

In some systems, a target is a magnet that generates a magnetic field. In such systems, the magnet may be the rotating object itself if the object is magnetized, or may otherwise be a magnet that is attached to the rotating object so as to rotate with the rotating object.

In some systems, a target may be made of a ferromagnetic material, such as a ferromagnetic steel (e.g., ferromagnetic carbon steel). In these systems, a magnet may generate a magnetic field, and deflections of the magnetic field may be sensed by the sensor device. For example, a target may be a ferromagnetic gear that may be rotated and that has gear teeth. A biasing magnet may be positioned in proximity to the ferromagnetic target and may generate a magnetic field. As the target rotates, the gear teeth of the target may cause deflections in (or modulate) the magnetic field generated by the biasing magnet. These deflections may be detected by one or more magnetic field sensing elements to determine a rotation speed, direction, position, and/or angle of the target. In some systems, the one or more magnetic field sensing elements of a sensor device may be positioned between a biasing magnet and a ferromagnetic target. Such an arrangement may be referred to herein as a "back-bias" arrangement.

A person of ordinary skill in the art would recognize that a magnet may be a permanent magnet that stays magnetized once magnetized, a temporary magnet that behaves like a magnet only when near a magnetic field, an electromagnet that behaves like a magnet only when electricity is applied, or any other type of magnet. A person of ordinary skill in the art would recognize that a magnet may be made of any type of magnetic material, such as neodymium (e.g., neodymium-iron-boron (NdFeB)), samarium cobalt (e.g., SmCo), alnico (e.g., aluminum, nickel, cobalt), ceramic or ferrite (e.g., strontium carbonate, iron oxide) or any other type of magnetic material. A magnet may be diametrically magnetized and/or axially magnetized. A magnet may have a north pole and a south pole, or several north poles and south poles. A magnet may take a variety of different forms, such as a disc magnet, a bar magnet, a horseshoe magnet, a ring magnet, or a cylinder magnet, as just some examples.

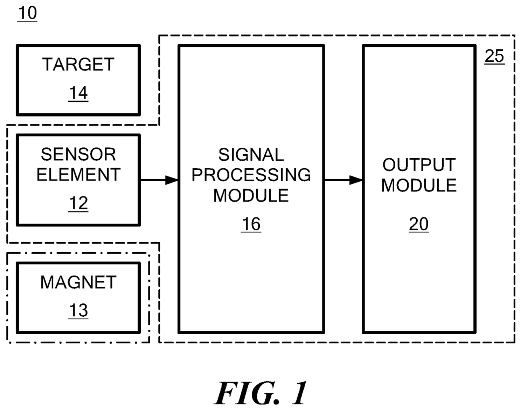

FIG. 1 shows a block diagram of an example system 10 for sensing a magnetic field. System 10 includes one or more magnetic field sensing elements 12. A magnet 13 may be positioned in relation to magnetic field sensing element(s) 12 and may generate a magnetic field. Magnet 13 may be any of the types of magnets previously discussed. A target 14 made of a ferromagnetic material may also be positioned in proximity to magnetic field sensing element(s) 12. As shown in FIG. 1, magnetic field sensing element(s) 12 may be positioned between magnet 13 and target 14, such that system 10 has a back-bias arrangement.

Magnetic field sensing element(s) 12 may sense changes in the magnetic field generated by magnet 13 as target 14 rotates and features (e.g., gear teeth) of target 14 pass by magnetic field sensing element(s) 12. For example, magnetic field sensing element(s) 12 may sense deflection (or modulation) of the magnetic flux lines of the magnetic field generated by magnet 13 as the features of target 14 pass by.

Alternatively, as discussed above, a target may itself be magnetized, such as a ring magnet with alternating magnetic poles. In such a case, magnet 13 may not be required, and magnetic field sensing element(s) 12 may sense changes in the magnetic field as the target rotates and the magnetic pole pairs of the ring magnet pass by magnetic field sensing element(s) 12.

A magnetic field sensing element may be any type of element sensitive to a magnetic field. A magnetic field sensing element may be a magnetoresistance element, a magnetotransistor element, or a Hall-effect element. For example, a magnetic field sensing element may be a magnetoresistance element, such as a giant magnetoresistance (GMR) element (e.g., a spin valve element), an Indium Antimonide (InSb) element, an anisotropic magnetoresistance (AMR) element, a tunneling magnetoresistance (TMR) element, or a magnetic tunnel junction (MTJ) element. A magnetic field sensing element may instead by a Hall-effect element, such as a planar Hall element, a vertical Hall element, or a circular vertical Hall (CVH) element.

As is known, some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. In particular, planar Hall elements tend to have axes of maximum sensitivity perpendicular to a substate, while metal-based or metallic magnetoresistance (e.g., GMR, TMR, AMR, spin-valve) and vertical Hall elements tend to have axes of maximum sensitivity parallel to a substrate.

A magnetic field sensing element may be a single element, or alternatively may include two or more magnetic field sensing elements. Magnetic field sensing elements may be arranged in one of various configurations, such as a half bridge or full (Wheatstone) bridge. Depending on the type of sensor device and application requirements, a magnetic field sensing element may be a device made of a type IV semiconductor material, such as Silicon (Si) or Germanium (Ge), or of a type III-V semiconductor material such as Gallium-Arsenide (GaAs) or an Indium compound such as Indium-Antimonide (InSb). In some embodiments, multiple magnetic field sensing elements in a sensor device may be of the same type of magnetic field sensing element. In some embodiments, there may be different types of magnetic field sensing elements that work together in a sensor device.

In some embodiments, a sensor device may comprise a magnetic field sensing element that comprises two magnetic field sensing elements that are differentially paired. For example, magnetic field sensing elements may be grouped in pairs, such that a difference between outputs of each of the pairs may be determined and output as a differential signal corresponding to the respective pair. Use of differentially-coupled magnetic field sensing elements in a sensor device may allow the sensor device to be immune to stray magnetic fields. For example, any magnetic field strength attributable to the environment, and not to a biasing magnet or to a target, may be sensed by each of the two magnetic field sensing elements in a differentially coupled pair. Because a magnetic field attributable to the environment will be approximately equally sensed at the two differentially paired magnetic field sensing elements (if they are in close proximity), any magnetic field strength measured by magnetic field sensing elements that is attributable to the environment will largely cancel out when a difference is taken between the measurements of the two differentially paired magnetic field sensing elements. That is, common-mode magnetic fields (i.e., common magnetic field strengths sensed by both magnetic field sensing elements in a differential pair) may be canceled out through use of differentially paired magnetic field sensing elements.

A signal processing module 16 may be coupled to magnetic field sensing element(s) 12 and may process signals received from the magnetic field sensing element(s) 12. For example, the signals produced by magnetic field sensing element(s) 12 in response to a sensed magnetic field may be relatively small. Accordingly, a signal processing module 16 may include amplifiers, filters, and/or other circuit components or other known techniques to amplify and/or shape the signals. In some embodiments, the signals may be processed and/or conditioned along channels, or signal paths, within signal processing module 16. Signal processing module 16 may include, for example, one or more amplifiers, analog-to-digital converters (ADCs), resistors, diodes, transistors, capacitors, inductors, memories, processors, and/or any other type of circuit component.

An output module 20 may be coupled to signal processing module 16 and may provide an output signal to another system, such as a controller or another type of system as further discussed herein. Output module 20 may include any suitable type of interface for outputting one or more signals. Output module 20 may include one or more of a wired or wireless interface. By way of example, output module 20 may include a current modulator for sending information along a conductor via current pulses, a voltage modulator for sending information along a conductor via voltage pulses, an Inter-Integrated Circuit (I²C) interface, a Controller Area Network (CAN) bus interface, a WiFi interface, an Ethernet interface, a Universal Serial Bus (USB) interface, a local area network (LAN) interface, a peripheral component interconnect (PCI) Express interface, a serial peripheral interface (SPI) interface, a universal asynchronous receiver/transmitter (UART) interface, a universal asynchronous/synchronous receiver/transmitter (USART) interface, a cellular (e.g., 5G) interface, and/or any other suitable type of interface.

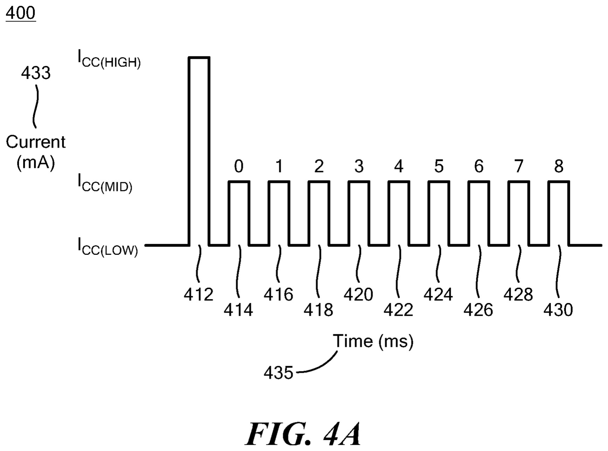

In some embodiments, information may be conveyed out of output module 12 as current pulses (see, e.g., FIGs. 4A-4C) or another type of output (e.g., voltage pulses) in accordance with a standardized protocol. In some embodiments, a sensor device may output information as an analog square wave having two different current levels representing two different states. In some embodiments, a sensor device may output information as an analog square wave having three different current levels representing three different states. In some embodiments, a sensor device may output information in accordance with an AK protocol. In some embodiments, a sensor device may output information as pulse-width modulated (PWM) signals. Any suitable known protocol, such as any known event-based protocol, may be used to output information from a sensor device.

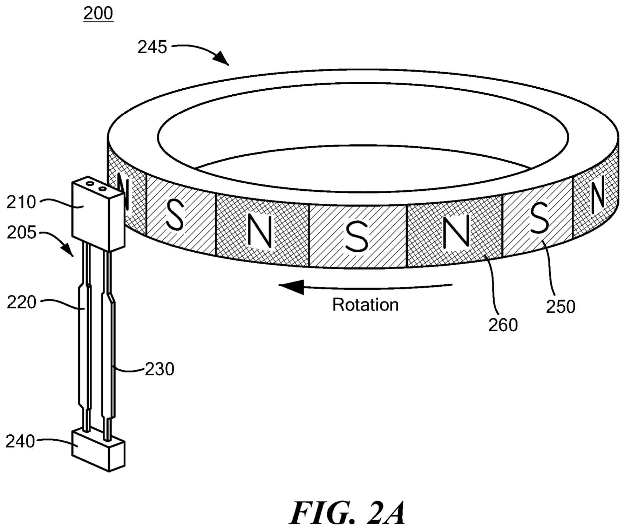

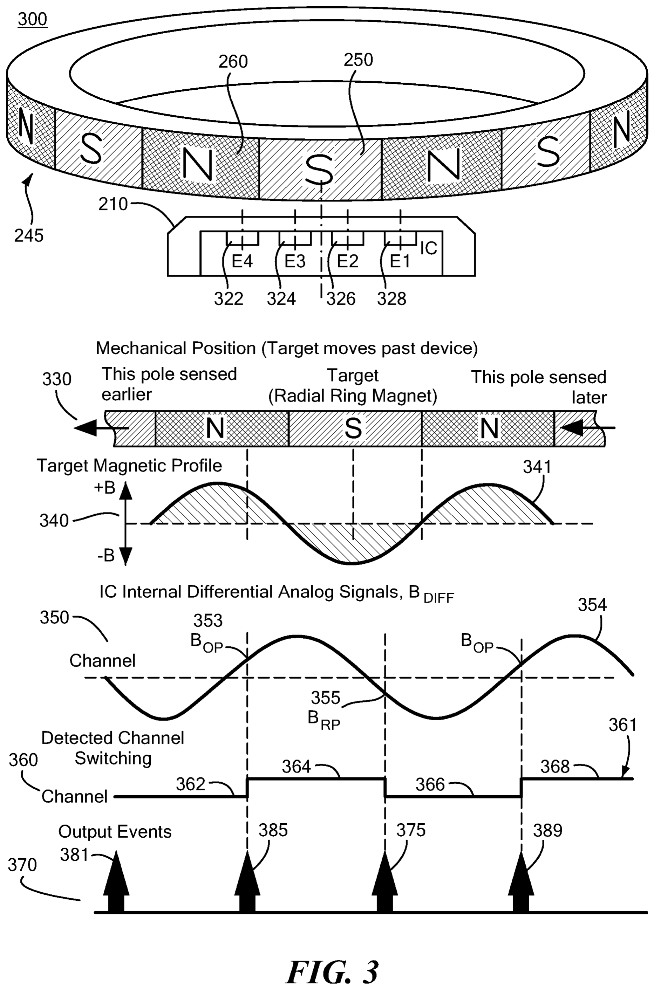

In some embodiments, a target 14 may be, for example, a magnetic target of the types or forms of magnets previously discussed. For example, a target 14 may be a ring magnet that may be rotated and that has sections of alternating magnetic polarity (e.g., alternating north and south poles) (see, e.g., target 245 of FIGs. 2A and 3), though the disclosure is not so limited. When such a magnetic target is used, magnet 13 (i.e., biasing magnet) may not be required.

In some embodiments, a target 14 may comprise a ferromagnetic material, as previously discussed. For example, target 14 may be a ferromagnetic gear that may be rotated and that has gear teeth. In such a case, a biasing magnet 13 may be used in a "back-bias" arrangement, and deflections of the magnetic field generated by biasing magnet 13 may be detected by one or more magnetic field sensing elements 12 as the gear teeth of ferromagnetic target 14 pass in proximity to the one or more magnetic field sensing elements.

In some embodiments, a sensor device 25 may comprise one or more magnetic field sensing elements 12, a signal processing module 16, and an output module 20. In some embodiments, a sensor device 25 may comprise one or more magnetic field sensing elements 12, a signal processing module 16, an output module 20, and a biasing magnet 13.

One or more magnetic field sensing elements 12, signal processing module 16, and/or output module 20 of sensor device 25 may be implemented with analog and/or digital circuitry. Additionally, it should be understood that sensor device 25 may comprise additional circuitry. As one example, comparators with two state output signals indicative of an input signal being above or below a threshold level may be included in sensor device 25. Sensor device 25 may also comprise one or more controllers, such as analog or digital controllers or digital processors.

FIG. 2A shows an example system 200, including a sensor device 205 and a magnetic target 245. Example sensor device 205 shown in FIG. 2A is a two-pin sensor device, however, a sensor device may include any number of pins for inputting and/or outputting signals to the sensor device. Components of sensor device 25 of FIG. 1, for example, may be placed in a package 210 (e.g., system-in-package (SIP) package) as shown in FIG. 2A. One of pins 220 and 230 may be a Vcc terminal and the other of pins 220 and 230 may be a ground (GND) terminal. 240 may be a structural piece (e.g., plastic piece) that holds pins 220 and 230 in position. Sensor device 205 may measure magnetic field signals of a target as it rotates. FIG. 2A shows an example where a target (e.g., target 14) is a ring magnet 245 with alternating magnetic poles (e.g., north poles 260, south poles 250). Ring magnet 245 may be attached to a larger rotating object, such as a wheel of a vehicle. Monitoring rotation of ring magnet 245 by sensing the magnetic fields associated with ring magnet 245 as it rotates may allow sensor device 205, or a system downstream of sensor device 205 (e.g., a power management integrated circuit (PMIC), an electronic control unit (ECU)) that receives information from sensor device 205, to determine characteristics of the object (e.g., wheel) to which ring magnet 245 is attached, such as a rotation speed and/or rotation direction of that object.

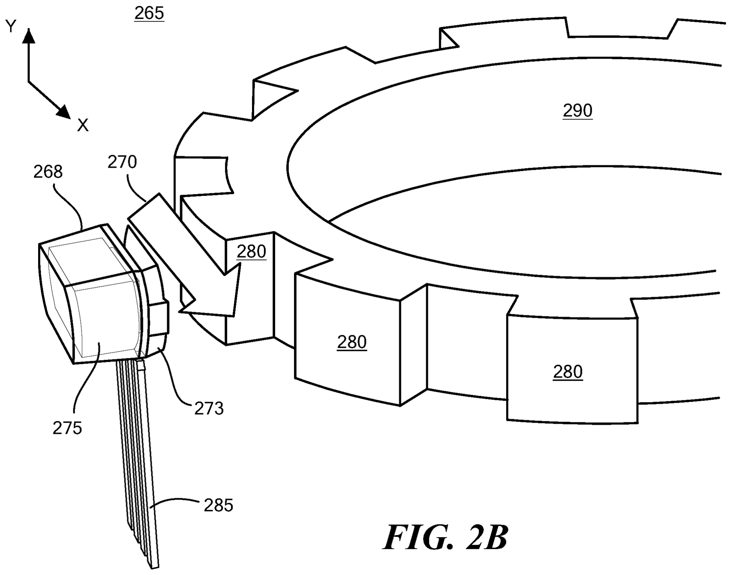

FIG. 2B shows another example system 265, including a sensor device 273 and a target 290. Example sensor device 273 shown in FIG. 2B is a four-pin sensor device, however, a sensor device may include any number of pins for inputting and/or outputting signals to the sensor device. Components of sensor device 25 of FIG. 1, for example, may be placed in sensor device 273. In some embodiments, one of the pins of sensor device 273 may be a Vcc terminal and another of the pins of sensor device 268 may be a ground (GND) terminal. Magnet 275 may be any of the types or forms of magnets previously discussed. In some embodiments, magnet 275 may correspond to magnet 13 of FIG. 1. For example, magnet 275 may be a bulk magnet used in a back-bias arrangement. Magnet 275 may be mounted to sensor device 273 (such as with an adhesive) or otherwise packaged with sensor device 273, so as to align magnet 275 with the magnetic field sensing elements of the sensor device.

In some embodiments, target 290 may be a ferromagnetic target with gear teeth 280. In the example of FIG. 2B, target 290 is rotating along an axis (e.g., along a Y-axis) past the sensor device in a direction 270 (e.g., an X-axis direction). As previously discussed, magnet 275 may generate a magnetic field, and magnetic field sensing elements in sensor device 273 may sense deflection of (or modulation of) the magnetic field as gear teeth 280 of target 290 rotate past the sensor device. The magnetic field sensing elements may be oriented so as to be sensitive to the magnetic field along the X-axis (or 270) direction, though the disclosure is not so limited.

A back-biasing magnet (e.g., magnet 275) may be packaged with circuitry of a sensor device (e.g., sensor device 273), such as in a package 268, such that the magnet and sensor device may be referred to herein collectively as a sensor device.

Monitoring rotation of ferromagnetic target 290 by sensing the deflections of the magnetic field generated by magnet 275 as the gear teeth of ferromagnetic target 290 pass the magnetic field sensing elements of sensor device 273 may allow sensor device 273, or a system downstream of sensor device 273 (e.g., a power management integrated circuit (PMIC), an electronic control unit (ECU)) that receives information from sensor device 273, to determine characteristics of the object (e.g., wheel) to which ferromagnetic target 290 is attached, such as a rotation speed and/or rotation direction of that object.

FIG. 3 shows an example target 245 (e.g., ring magnet) and an example sensor device 210. Example target 245 may have alternating north 260 and south 250 poles. Example sensor device 210 may include two magnetic field sensing elements, each of which may comprise two differentially-coupled magnetic field sensing elements. That is, a magnetic field sensing element corresponding to one channel may comprise magnetic field sensing elements E1 328 and E3 324, differentially coupled, and a magnetic field sensing element corresponding to another channel may comprise magnetic field sensing elements E2 326 and E4 322, differentially coupled. In some embodiments, magnetic field sensing element E1 328 may be physically spaced approximately 1.5 mm apart from magnetic field sensing element E3 324, and magnetic field sensing element E2 326 may be physically spaced approximately 1.5 mm apart from magnetic field sensing element E4 322, though the disclosure is not so limited.

FIG. 3 also shows diagrams and plots, including a diagram 330 of example mechanical positions of target 245, a graph 340 of an example corresponding magnetic profile of the target, a graph 350 of an example corresponding magnetic field signal measured by the sensor device, a graph 360 of example corresponding detected channel switching events, and a graph 370 of example corresponding output events based on the detected channel switching events.

Diagram 330 shows example mechanical positions of the target, with alternating north and south poles that pass by the sensor device as the target rotates. Graph 340 shows an example magnetic profile of the target corresponding to the mechanical positions of the target shown in diagram 330. The Y-axis of graph 340 represents amplitude of the magnetic field in Tesla. The X-axis of graph 340 corresponds to the mechanical positions of the target shown in diagram 330. Plot 341 represents the magnetic field strength sensed in a channel of sensor device 210 when the corresponding mechanical position shown in diagram 330 is centered over sensor device 210.

Graph 350 shows an example magnetic field signal measured by the sensor device. The Y-axis of graph 350 may represent, for example, a measured amplitude (e.g., voltage) that represents the magnetic field strength of the target, and the X-axis of graph 350 corresponds to the mechanical positions of the target shown in diagram 330. Plot 354 represents the magnetic field strength measured by a channel of the sensor device when the corresponding mechanical position shown in diagram 330 is centered over sensor device 210. In this example, plot 354 corresponds to a measured magnetic field signal that is the result of two differentially-coupled magnetic field sensing elements in a channel. That is, the measured magnetic field strength (i.e., B_{DIFF}) at any mechanical position of the target may correspond to a difference between the magnetic field strengths at two different differentially-coupled magnetic field sensing elements within a channel. A first threshold level value (e.g., B_{RP} 355) may correspond to 40% of the peak-to-peak value of the B_{DIFF} signal, and a second threshold level value (e.g., B_{OP} 353) may correspond to 60% of the peak-to-peak value of the B_{DIFF} signal, though the disclosure is not so limited. Graph 350 illustrates where the thresholds are exceeded by the B_{DIFF} signal.

Graph 360 shows an example channel output signal corresponding to the mechanical positions of the target shown in diagram 330. The Y-axis of graph 360 represents an amplitude of a channel output signal, such as an amplitude in voltage or current, and the X-axis of graph 360 corresponds to the mechanical positions of the target shown in diagram 330. Plot 361 shows how the amplitude of the channel output signal may transition between binary states (e.g., voltage levels or current levels corresponding to 0s and 1s) when predetermined threshold level values (e.g., B_{OP}, B_{RP}) are crossed by a measured magnetic field signal of a channel. In this example, the channel output signal transitions from a 0 362 to a 1 364 when the B_{OP} threshold level value is crossed, from 1 364 to 0 366 when the B_{RP} threshold is crossed, and from 0 366 to 1 368 when the B_{OP} threshold level value is again crossed.

Graph 370 shows example output events corresponding to the mechanical positions of the target shown in diagram 330. The arrows (e.g., arrow 381, arrow 385, arrow 375, arrow 389) correspond to the output events. In general, each output event corresponds to a channel switching based on a detection of a measured magnetic field signal crossing a threshold level value. In some embodiments, one or more different pulses of current or voltage may be output in response to an output event.

A sensor device (e.g., sensor device 25, sensor device 205, sensor device 273, sensor device 210, sensor device 505, sensor device 526, sensor device 585, sensor device 705, sensor device 1510) may transmit information (e.g., via current pulses or voltage pulses) via an output interface (e.g., output module 20) to another device (e.g., a PMIC, ECU, other system) based on identified channel switching states. For example, information may be transmitted by transmitting current signals at one of two different levels, though the disclosure is not so limited. In some embodiments, information may be transmitted by transmitting signals at one of three different levels, though the disclosure is not so limited. A person of ordinary skill in the art would recognize that signals could transmitted at any number of different levels to convey a variety of different types of information. In some embodiments, information may be transmitted in accordance with a protocol, such as an AK protocol or a PWM protocol.

FIG. 4A shows a graph 400 with a plot of example output current pulses that convey information about a target in accordance with an AK protocol. Graph 400 includes a Y-axis 433 representing current (e.g., in milliamps (mA)) and an X-axis 435 representing time (e.g., in milliseconds (ms)). A plot shows a possible analog square wave of an example output event. One example of an output event of a sensor device, in accordance with AK protocol, may be a word consisting of 10 possible pulses - a single speed pulse, 8 additional possible pulses representing additional information bits, and one possible pulse representing a parity bit. FIG. 4A shows an example implementation of an AK protocol word having ten possible pulses. The example AK protocol word of FIG. 4A has three different possible current levels associated with different pieces of information conveyed by the word. For example, a speed pulse 412 may be output at a current level I_{CC(HIGH)}. Bits (e.g., 414, 416, 418, 420, 422, 424, 426, 428, 430) associated with other pieces of information of the word may be output at a current level of either I_{CC(MID)} (e.g., corresponding to a 1) or I_{CC(LOW)} (e.g., corresponding to a 0), though the disclosure is not so limited. In some embodiments, I_{CC(HIGH)} may correspond to approximately 28 mA, I_{CC(MID)} may correspond to approximately 14 mA, and I_{CC(LOW)} may correspond to approximately 7 mA, though the disclosure is not so limited.

In some embodiments, speed pulses (e.g., pulse 412) of output events may be used by a downstream system (e.g., a PMIC, an ECU, other system) to determine a speed of rotation of a target (e.g., target 14, target 245, target 290) or of an object to which a target is attached. As a target rotates more quickly (i.e., at greater frequency), more pole pairs (for a magnetic target) or gear teeth (for a ferromagnetic target) will pass by the sensor device within a given period of time. A downstream system (e.g., a PMIC, an ECU, other system) may look at the timing at which it receives speed pulses and use that timing to determine a speed of rotation of the target or object. The other bits of a word (e.g., bits 414, 416, 418, 420, 422, 424, 426, 428, 430) may represent other information about the target, such as information about an air gap between the sensor device and the target, a direction of rotation of the target, information regarding which event (e.g., switching event) triggered the output event, vibration information, parity information, or any other information about the target or sensor device.

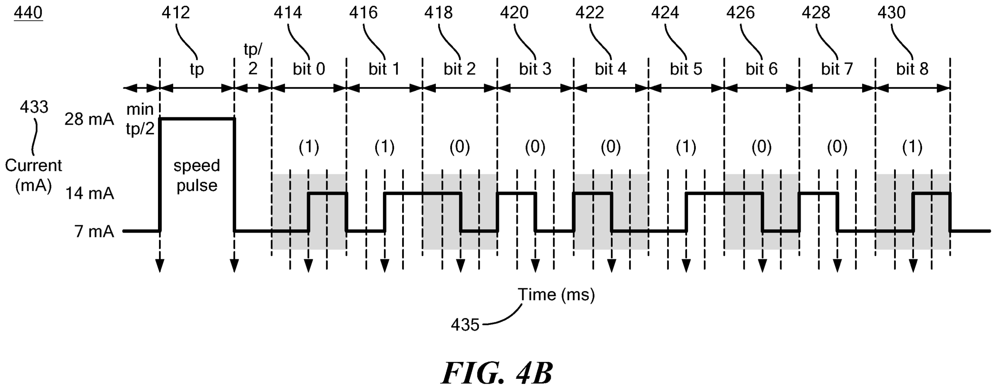

FIG. 4B shows a graph 440 with another plot of example output current pulses that convey information about a target in accordance with an AK protocol. Graph 440 includes a Y-axis 433 representing current (e.g., in mA) and an X-axis 435 representing time (e.g., in ms). A plot shows a possible square wave of an example output event. As previously discussed above with respect to FIG. 4A, an output event of a sensor device, in accordance with AK protocol, may be a word consisting of 10 possible pulses, a single speed pulse, 8 additional possible pulses representing additional information bits, and one possible pulse representing a parity bit. FIG. 4B shows an example implementation of an AK protocol word having ten possible pulses. The example AK protocol word of FIG. 4B has three different possible current levels associated with different pieces of information conveyed by the word. For example, a speed pulse 412 may be output at a current level I_{CC(HIGH)} (shown in FIG. 4B as 28 mA). Bits (e.g., 414, 416, 418, 420, 422, 424, 426, 428, 430) associated with other pieces of information of the word may be output at a current level of either I_{CC(MID)} (shown in FIG. 4B as 14 mA) or I_{CC(LOW)} (shown in FIG. 4B as 7 mA), though the disclosure is not so limited. In some embodiments, a system (e.g., PMIC, ECU, other system) receiving a signal including such a word may interpret a current level at 14 mA at a certain time as representing a logic high level (or "1") and a current level at 7 mA at a certain time as representing a logic low level (or "0"), though the disclosure is not so limited.

In some embodiments, a system (e.g., PMIC, ECU, other system) receiving a signal including such a word may interpret the signal at certain periods of time based on a transition that occurs within that period of time. For example, a transition from I_{CC(LOW)} (e.g., 7 mA) to I_{CC(MID)} (e.g., 14 mA) in a period of time within a word may be interpreted as representing a "1" for the bit corresponding to that period of time, while a transition from I_{CC(MID)} (e.g., 14 mA) to I_{CC(LOW)} (e.g., 7 mA) in a period of time within a word may be interpreted as representing a "0" for the bit corresponding to that period of time. Thus, in the example word shown in FIG. 4B, 414 (bit 0) may be interpreted as a "1", 416 (bit 1) may be interpreted as a "1", 418 (bit 2) may be interpreted as a "0", 420 (bit 3) may be interpreted as a "0", 422 (bit 4) may be interpreted as a "0", 424 (bit 5) may be interpreted as a "1", 426 (bit 6) may be interpreted as a "0", 428 (bit 7) may be interpreted as a "0", and 430 (bit 8) may be interpreted as a "1". 412, being at a highest current level (28 mA) may be interpreted as a speed pulse.

As discussed above with respect to FIG. 4A, in some embodiments, speed pulses (e.g., pulse 412) may be used by a downstream system (e.g., PMIC, ECU, other system) to determine a speed of rotation of a target (e.g., target 14, target 245, target 290) or of an object to which a target is attached. As a target rotates more quickly (i.e., at greater frequency), more pole pairs (for a magnetic target) or gear teeth (for a ferromagnetic target) will pass by the sensor device within a given period of time. A downstream system (e.g., PMIC, ECU, other system) may look at the timing at which it receives speed pulses and use that timing to determine a speed of rotation of the target or object. The other bits of a word (e.g., bits 414, 416, 418, 420, 422, 424, 426, 428, 430) may represent other information about the target, such as information about an air gap between the sensor device and the target, a direction of rotation of the target, information regarding which event (e.g., switching event) triggered the output event, vibration information, parity information, or any other information about the target or sensor device.

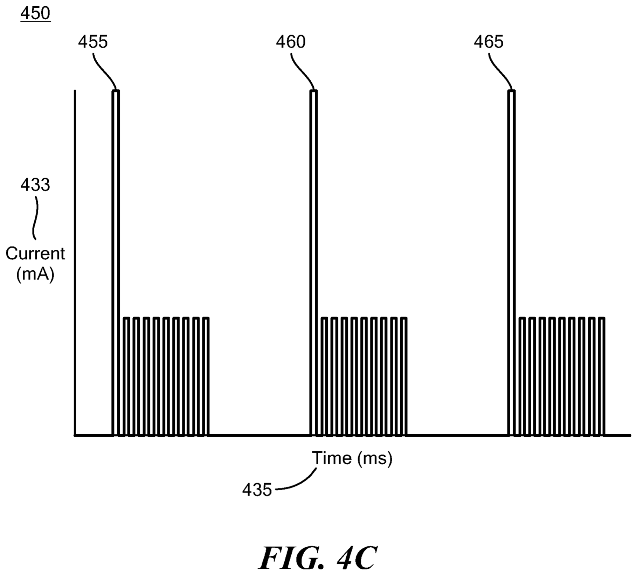

FIG. 4C shows a graph 450 with a plot of example sets of output current pulses that convey information about a target. Graph 450 includes a Y-axis 433 representing current (e.g., in mA) and an X-axis 435 representing time (e.g., in ms). FIG. 4C shows an example output sequence of example AK protocol words (see, e.g., FIGs. 4A and 4B and associated descriptions) from a sensor device. For example, pulse train 455 represents one example AK protocol word, pulse train 460 represents another example AK protocol word, and pulse train 465 represents yet another example AK protocol word. **In** some embodiments, the lowest level of current in an AK protocol word (e.g., I_{CC(LOW)}) for bits of the AK protocol word may be a nonzero amount of current (e.g., 7 mA), and may represent a "0". A higher level of current (e.g., I_{CC(MID)}) for bits of the AK protocol word may be, for example, 14 mA, and may represent a "1"). A highest level of current (e.g., I_{CC(HIGH)}) may be output for speed pulses and may be, for example, 28 mA.

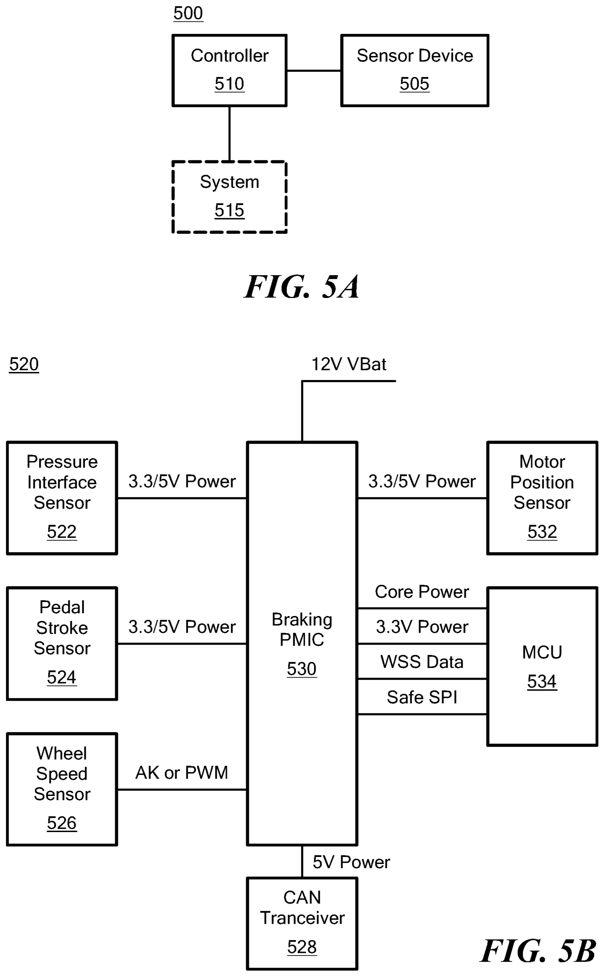

FIG. 5A shows a block diagram of an example system 500 including one or more sensor devices 505 and a controller 510. In some embodiments, a sensor device 505 may be the same as sensor device 25, sensor device 205, sensor device 273, or sensor device 210, though the disclosure is not so limited. As previously discussed, one or more signals (e.g., current signals, voltage signals) output from a sensor device 505 may be received by one or more systems (e.g., PMIC, ECU, other system). Controller 510 may be a system, such as a PMIC or ECU, or may otherwise be a circuit or controller (e.g., analog controller, digital controller, processor) within a system, that receives the signal(s) output from sensor device(s) 505. In some embodiments, controller 510 may process the signal(s) received from sensor device(s) 505. For example, controller 510 may be a system that measures a current of the signal(s) received from a sensor device 505. In some embodiments, controller 510 may decode the signal(s) received from a sensor device 505 based on current levels received at certain times in the signal(s). For example, controller 510 may determine whether a current level corresponds to a speed pulse or to a "1" or a "0" of a particular bit of an AK protocol word. In some embodiments, a controller 510 may be connected to a number of different sensor devices 505. For example, one sensor device 505 may be a wheel speed sensor that sends information about a speed of rotation of a wheel, as discussed above. A controller 510 may also receive information from other types of sensors, such as rotation angle sensors, pressure sensors, temperature sensors, or any other type of sensor that may be useful in a particular application.

In some embodiments, controller 510 may be a PMIC. A PMIC may comprise an IC with internal circuitry designed to manage power requirements of a system. A PMIC may receive power, such as from a car battery, and may convert and/or regulate that power to provide one or more regulated voltage levels for one or more components (e.g., sensors) of a system. A PMIC may comprise, for example, one or more linear regulators, buck converters, boost converters, buck-boost converters, flyback converters, or other known types of power converters. In some embodiments, the PMIC may be provide a regulated voltage (e.g., Vcc) to sensor device(s) 505. In some embodiments, the PMIC may also comprise a system that measures a current of signal(s) received from sensor device(s) 505. In some embodiments, the PMIC may decode the signal(s) received from sensor device(s) 505. For example, the PMIC may decode the signal(s) (e.g., an analog square wave signal) received from a wheel speed sensor based on current levels received at certain times in the signal(s). As previously discussed, the PMIC may identify speed pulses and "1s" and "0s" corresponding to particular bits of an AK protocol word based on measured current levels of a received signal (e.g., square wave signal) at certain times.

In some embodiments, controller 510 may output one or more signals to another system 515 based on the one or more signals it received from sensor device 510. System 515 may be, for example, an MCU (e.g., MCU 534) or ECU of an automobile. In some embodiments, controller 510 may output the information interpreted from the one or more signals received from sensor device 505 in another format to system 515, such as over a serial peripheral interface (SPI), controller area network (CAN) bus, or other type of interface.

FIG. 5B shows a block diagram of another example system 520 including one or more sensor devices and a controller. In the example of FIG. 5B, the controller is a PMIC 530 that provides power management for various components related to automobile braking in system 520. As shown, PMIC 530 may receive power (e.g., 12 Volts) from a power source (e.g., a car battery), and may provide one or more regulated voltages to various other components of system 520. In the example of FIG. 5B, PMIC 530 provides 3.3V and/or 5V to a pressure interface sensor 522, 3.3V and/or 5V to a pedal stroke sensor 524, a desired voltage level to wheel speed sensor 526, 5V to a CAN transceiver 528, 3.3V and/or a core power level to a microcontroller unit (MCU) 534 (e.g., an ECU), and 3.3V and/or 5V to a motor position sensor 532. In some embodiments, MCU 534 may correspond to system 515 of FIG. 5A, though the disclosure is not so limited. As shown in FIG. 5B, wheel speed sensor 526 may provide information (e.g., wheel speed and other information) to PMIC as an analog square wave current signal (e.g., a two-level or three-level current signal, such as an AK protocol or PWM signal). As previously discussed, PMIC 530 may interpret the information and send it in another form to MCU 534 (e.g., as wheel speed sensor (WSS) data). Other safety information may also be conveyed from PMIC 530 to MCU 534 (e.g., as Safe SPI data).

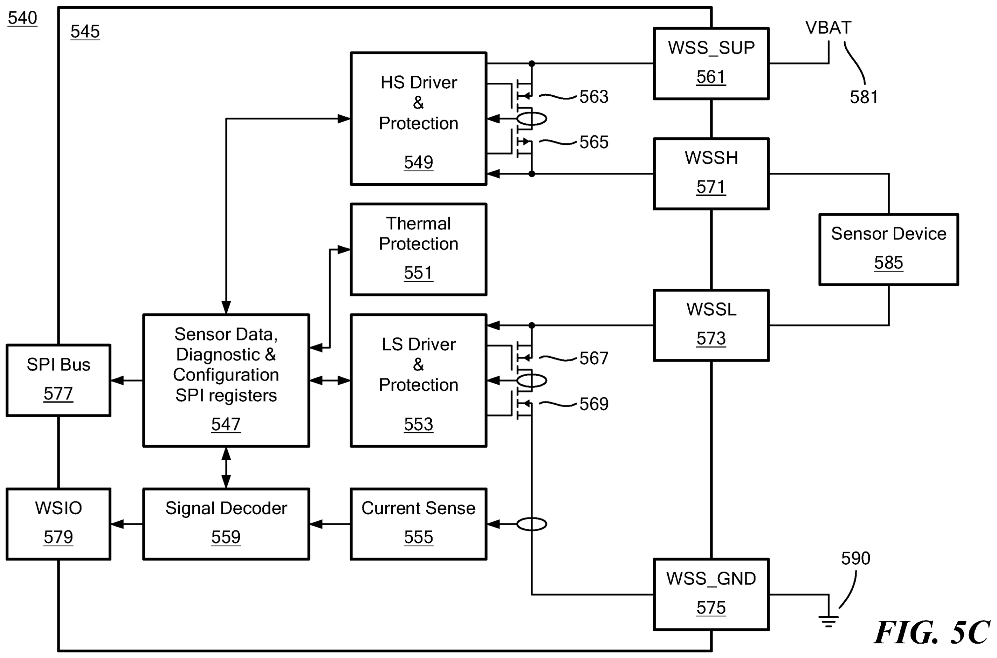

FIG. 5C shows a block diagram of still another example system 540 including one or more sensor devices and a controller 545. In the example of FIG. 5C, the controller is a system that delivers power to a wheel speed sensor device 585, that measures current from the analog square wave current signal output from wheel speed sensor device 585, and that decodes information from the analog square wave current signal transmitted from the wheel speed sensor device 585 based on the measured current levels at particular times. In some embodiments, controller 545 may be a part of a larger system, such as a PMIC (e.g., PMIC 530) or an ECU.

As shown in FIG. 5C, voltage from a power source, such as a battery (VBAT) 581 or a different regulated voltage, may be coupled to an input (high side) of a wheel speed sensor device 585 through a wheel speed sensor supply (WSS_SUP) input pin 561 and a wheel speed sensor high side (WSSH) output pin 571 of controller 545. Controller 545 may also include high side (HS) driver and protection circuitry 549. HS driver and protection circuitry may monitor the voltage and/or current being provided to wheel speed sensor device 585, and may control transistors 563, 565 to block the voltage and current from being provided to wheel speed sensor device 585 when the voltage and/or current exceeds and/or falls below a predetermined threshold value, to thereby protect the wheel speed sensor device 585 from failing or to otherwise prevent unreliable wheel speed sensor signals from being output to other components (e.g., an ECU) of system.

A signal (e.g., an analog square wave current signal) may be output from wheel speed sensor device 585 and received by controller 545 at a wheel speed sensor low side (WSSL) input pin 573. This current may flow to a ground potential through a ground (WSS_GND) output pin 575 of controller 545. Current sense circuitry 555 may also measure this current to determine a level of the analog square wave current signal output from wheel speed sensor device 585 at a given time. A person of ordinary skill in the art would recognize that there are a variety of known techniques for sensing current in a circuit. Any of these known techniques could be used in current sense circuitry 555, and the disclosure herein should be interpreted as encompassing these known techniques. As just one example, current sense circuitry 555 may include a resistor of a known value in the path of the current being sensed, such that a voltage across the resistor can be measured and the current determined from that measured voltage. Current sense circuitry 555 may be internal or external to controller 545.

Controller 545 may also include low side (LS) driver and protection circuitry 553. LS driver and protection circuitry 553 may monitor the current being provided from wheel speed sensor device 585, and may control transistors 567, 569 to block the current from flowing when the current exceeds and/or falls below a predetermined threshold value, to thereby prevent current sensor circuitry 555 from measuring a current value that is erroneous and that should not be relied upon in making determinations related to wheel speed.

Once the current level of the analog square wave current signal output from wheel speed sensor device 585 has been measured, the measured current may be decoded by signal decoder circuitry 559. For example, if the analog square wave current signal received from wheel speed sensor device 585 is a two-level current signal, signal decoder circuitry 559 may determine which of the two levels the measured current corresponds to at a given time to identify speed pulses and/or any other information conveyed by the two-level current signal. If the analog square wave current signal received from wheel speed sensor device 585 is a three-level current signal, such as an AK protocol signal, signal decoder circuitry 559 may determine which of the three levels the measured current corresponds to at a given time to identify speed pulses (e.g., 28 mA current level), "1s" (e.g., 14 mA current level), and "0s" (e.g., 7 mA current level) of the AK protocol signal. In some embodiments, signal decoder circuitry 559 may comprise one or more comparators for determining the predetermined level to which the measured current corresponds. In some embodiments, signal decoder circuitry 559 may comprise hysteresis circuitry with one or more comparators that determine the predetermined level to which a measured current corresponds, and that further determines that the measured current corresponds to that predetermined level for a predetermined period of time, so as to not to consider spurious noisy signals. Although comparators are discussed above, the disclosure is not so limited. A person of ordinary skill in the art would recognize there are a number of known ways for determining whether a current signal exceeds or falls below a predetermined threshold, and any of these techniques could be used to implement signal decoder circuitry 559 and should be considered to be within the scope of the disclosure herein.

Once the measured current of the analog square wave current signal has been decoded, the information determined by decoding that signal may be output through wheel speed interface output (WSIO) pin(s) 579 to an external system (e.g., ECU, MCU). For example, the interface connected to WSIO pin(s) 579 may be a digital interface that sends voltage levels indicative of "1s" and "0s", an Inter-Integrated Circuit (I²C) interface, a serial peripheral interface (SPI), a universal asynchronous receiver transmitter/universal synchronous asynchronous receiver transmitter (UART/USART) interface, a Controller Area Network (CAN) bus interface, a peripheral component interconnect (PCI) (e.g., PCI Express) interface, parallel interface, a serial interface, a Universal Serial Bus (USB) interface, a local area network (LAN) interface, a WiFi interface, a Bluetooth interface, an Ethernet interface, a cellular (e.g., 5G) interface, an analog interface, and/or any other suitable type of interface.

Controller 545 may also include thermal protection circuitry 551. Thermal protection circuitry 551 may determine when the temperature of controller 545 exceeds or falls below a predetermined threshold, such that controller 545 may fail or otherwise provide inaccurate measurements. When such a threshold is breached, thermal protection circuitry 551 may output a signal indicating that such a condition has occurred and/or may otherwise shut down components of controller 545.

Controller 545 may also include registers 547. Registers 547 may store values from other components of controller 545, the values representing information such as whether protection by HS driver and protection circuitry 549 has been enabled, whether protection by thermal protection circuitry 551 has been enabled, and/or whether protection by LS driver and protection circuitry 553 has been enabled. Registers 547 may also store the level of the measured signal as determined by signal decoder circuitry 559.

In some embodiments, values stored in registers 547 may be read out of the registers by an external system (e.g., MCU 534, an ECU) over an SPI bus through SPI bus pin(s) 577. For example, an external system may read one or more values of decoded levels from current measurements, one or more values regarding protection features of HS driver and protection circuitry 549, one or more values regarding protection features of thermal protection circuitry 551, and/or one or more values regarding protection features of LS driver and protection circuitry 553 from registers 547.

One potential problem in sensing and decoding an analog square wave signal received from a wheel speed sensor device, as discussed above, is that the current levels of the analog square wave signal may be offset due to some imperfection in the wheel speed sensor, in the connection between the wheel speed sensor and the controller, or within the controller. For example, faulty wiring or connections, damaged components, loose connections, and/or environmental conditions such as moisture or temperature variations, may cause the current levels of the analog square wave output from a wheel speed sensor device to be offset when it is received by the controller. In some embodiments, such an imperfection can cause a resistive short to be present somewhere in the connections between the wheel speed sensor device and the controller, which may cause the current levels of the analog square wave to be offset. Such an offset may cause current sensing circuitry (e.g., current sense circuitry 555) to measure an incorrect amount of current, and in some cases may cause signal decoder circuitry (e.g., signal decoder 559) to thereby interpret the measured current as being a level that is different (or incorrect) from the level that should have been determined.

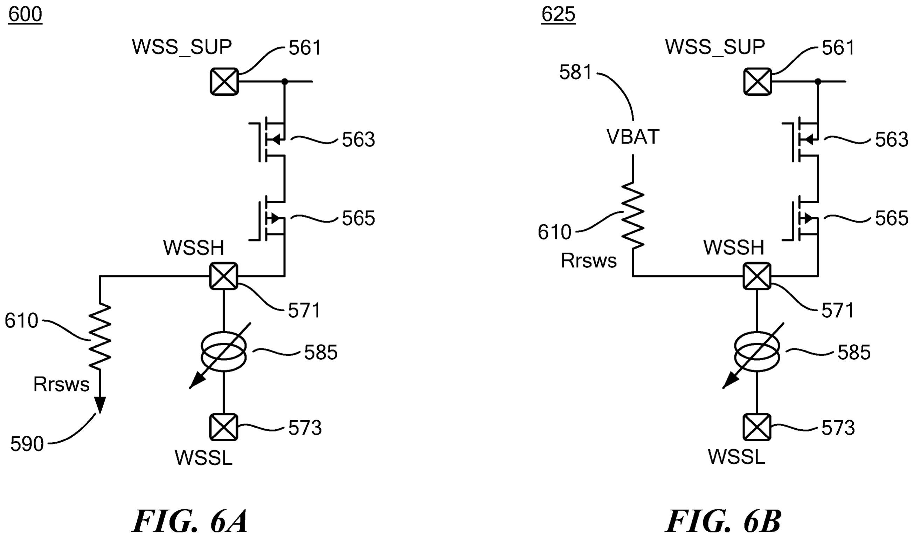

FIGs. 6A-6D show circuit diagrams illustrating example locations where resistive shorts may occur in the connections between a controller (e.g., controller 510, controller 530, controller 545, controller 710, controller 845) and a wheel speed sensor device (e.g., sensor device 25, sensor device 205, sensor device 273, sensor device 210, sensor device 505, sensor device 526, sensor device 585, sensor device 705).

FIGs. 6A and 6B show circuit diagrams illustrating example locations where a resistive short may be coupled to a high side input (e.g., input from WSSH pin 571) of a sensor device (e.g., sensor device 585).

In circuit diagram 600 of FIG. 6A, terminal 561 (WSS_SUP) corresponds to terminal 561 (WSS_SUP) of FIG. 5C, terminal 571 (WSSH) corresponds to terminal 571 (WSSH) of FIG. 5C, terminal 573 (WSSL) corresponds to terminal 573 (WSSL) of FIG. 5C, ground 590 corresponds to ground 590 of FIG. 5C, variable current generator 585 corresponds to sensor device 585 of FIG. 5C, transistor 563 corresponds to transistor 563 of FIG. 5C, and transistor 565 corresponds to transistor 565 of FIG. 5C. As shown in example circuit diagram 600 of FIG. 6A, a resistive short (R_{rsws}) 610 may be present between the high side input (WSSH 571) of sensor device 585 and ground 590. Such a resistive short may cause the amount of current flowing into sensor device 585 to be reduced.

In circuit diagram 625 of FIG. 6B, terminal 561 (WSS_SUP) corresponds to terminal 561 (WSS_SUP) of FIG. 5C, terminal 571 (WSSH) corresponds to terminal 571 (WSSH) of FIG. 5C, terminal 573 (WSSL) corresponds to terminal 573 (WSSL) of FIG. 5C, a voltage of the power source (e.g., car battery) (VBAT) 581 corresponds to VBAT 581 of FIG. 5C, variable current generator 585 corresponds to sensor device 585 of FIG. 5C, transistor 563 corresponds to transistor 563 of FIG. 5C, and transistor 565 corresponds to transistor 565 of FIG. 5C. As shown in example circuit diagram 625 of FIG. 6B, a resistive short (R_{rsws}) 610 may be present between the high side input (WSSH 571) of sensor device 585 and the voltage of the power source (VBAT) 581. Such a resistive short may cause the amount of current flowing into sensor device 585 to be increased.

In the examples discussed above with respect to FIGs. 6A and 6B where a resistive short is coupled to a high side input (e.g., input from WSSH pin 571) of a sensor device (e.g., sensor device 585), there may be no effect on current sensing and interpretation by the controller (e.g., controller 545), because as shown in FIG. 5C, the current sensing may be performed on the current being received from the sensor device (e.g., via WSSL pin 573). In some embodiments, protection features of HS driver and protection circuitry 549 may detect any issues with the high side current (e.g., current flowing into sensor device 585 via WSSH pin 571) and may take an appropriate action (e.g., turn off transistor 563, turn off transistor 565, shut down controller 545) if this high side current becomes too high (e.g., resistance of resistive short becomes too low) or too low.

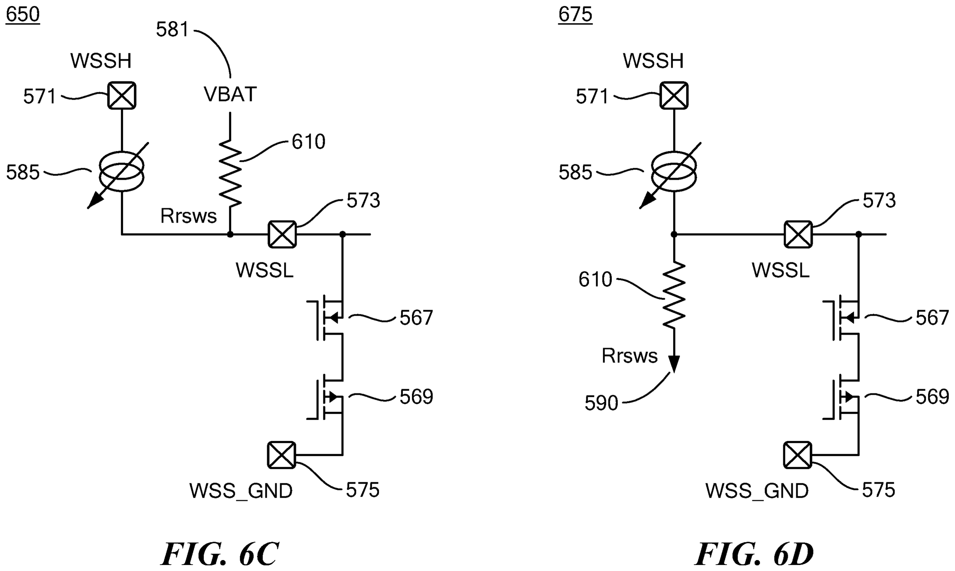

FIGs. 6C and 6D show circuit diagrams illustrating example locations where a resistive short may be coupled to a low side output (e.g., output to WSSL pin 573) of a sensor device (e.g., sensor device 585).

In circuit diagram 650 of FIG. 6C, terminal 571 (WSSH) corresponds to terminal 571 (WSSH) of FIG. 5C, terminal 573 (WSSL) corresponds to terminal 573 (WSSL) of FIG. 5C, terminal 575 (WSS_GND) corresponds to terminal 575 (WSS_GND) of FIG. 5C, a voltage of the power source (e.g., car battery) (VBAT) 581 corresponds to VBAT 581 of FIG. 5C, variable current generator 585 corresponds to sensor device 585 of FIG. 5C, transistor 567 corresponds to transistor 567 of FIG. 5C, and transistor 569 corresponds to transistor 569 of FIG. 5C. As shown in example circuit diagram 650 of FIG. 6C, a resistive short (R_{rsws}) 610 may be present between the low side output of sensor device 585 and the voltage of the power source (VBAT) 581. Such a resistive short may cause the amount of current flowing into terminal 573 (WSSL) of the controller (e.g., controller 545) to be greater than the amount of current flowing out of sensor device 585. That is, the amount of current received at terminal 573 (WSSL) and measured and interpreted within controller 545 may be different than the amount of current output from sensor device 585 by some offset that may be attributed to the extra current flowing from the power source (VBAT) 581 through resistive short 610.

In circuit diagram 675 of FIG. 6D, terminal 571 (WSSH) corresponds to terminal 571 (WSSH) of FIG. 5C, terminal 573 (WSSL) corresponds to terminal 573 (WSSL) of FIG. 5C, terminal 575 (WSS_GND) corresponds to terminal 575 (WSS_GND) of FIG. 5C, a ground 590 corresponds to ground 590 of FIG. 5C, variable current generator 585 corresponds to sensor device 585 of FIG. 5C, transistor 567 corresponds to transistor 567 of FIG. 5C, and transistor 569 corresponds to transistor 569 of FIG. 5C. As shown in example circuit diagram 675 of FIG. 6D, a resistive short (R_{rsws}) 610 may be present between the low side output of sensor device 585 and ground 590. Such a resistive short may cause the amount of current flowing into terminal 573 (WSSL) of the controller (e.g., controller 545) to be less than the amount of current flowing out of sensor device 585. That is, the amount of current received at terminal 573 (WSSL) and measured and interpreted within controller 545 may be different than the amount of current output from sensor device 585 by some offset that may be attributed to the current diverted from the output of sensor device 585 to ground 590 through resistive short 610.

In the examples discussed above with respect to FIGs. 6C and 6D where a resistive short is coupled to a low side output (e.g., output to WSSL pin 573) of a sensor device (e.g., sensor device 585), there may be an effect on current sensing and interpretation by the controller (e.g., controller 545), because as shown in FIG. 5C, the current sensing may be performed on the current being received from the sensor device (e.g., via WSSL pin 573). For example, as discussed above, a resistive short positioned as shown in FIG. 6C may cause a positive offset in the amount of current flowing into terminal 573 (WSSL), which may lead to an incorrect amount of current being measured by the controller. As also discussed above, a resistive short positioned as shown in FIG. 6D may cause a negative offset in the amount of current flowing into terminal 573 (WSSL), which may lead to an incorrect amount of current being measured by the controller. Moreover, as the amount of current diverted through the resistive short in FIG. 6D increases, the gain of the current signal input to terminal 573 (WSSL) is reduced, and at some point the gain may be reduced to a level that can no longer be measured by the controller (e.g., controller 545). In some cases, the offsets created by resistive shorts positioned as shown in FIGs. 6C and 6D may cause the current level of the analog square wave signal output from the sensor device to be decoded (or interpreted) incorrectly, which may result in accuracy or safety issues when the controller or other systems (e.g., MCU 534, an ECU) rely on the decoded values.

Systems and methods disclosed herein may address these potential problems. Disclosed are example systems and methods for detecting and compensating for an offset in a signal, such as a signal received from a sensor device. In particular, described are example systems and methods for detecting and compensating for an offset, such as a current offset, in an analog square wave signal. As discussed above, an offset in a signal received from a sensor device may occur, for example, when a resistive short exists somewhere in a circuit coupling the signal output from the sensor device to components that detect a level of the signal output from the sensor device. Using systems and methods disclosed herein, such an offset may be detected, and the signal can be compensated, such that the signal can be accurately detected and interpreted.

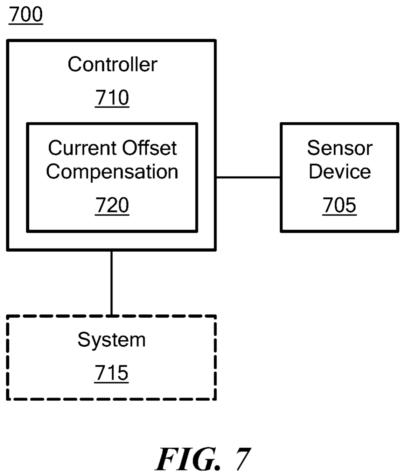

FIG. 7 shows a diagram of an example system 700 for detecting and compensating for an offset of an output received from a sensor device. Like system 500 of FIG. 5A, system 700 may include a sensor device and a controller. Sensor device 705, for example, may be the same as sensor device 505 (or the same as sensor device 25, sensor device 205, sensor device 273, sensor device 210, sensor device 526, or sensor device 585). Controller 710 may be similar to controller 510 (or controller 530 or controller 545), but may now include a current offset compensation system 720. Current offset compensation system 720 may detect an offset in the analog square wave current signal received from the sensor device, and may compensate for that offset. Current offset compensation system 720 may detect and compensate for offsets quickly (e.g., in near real-time) such that current levels of the analog square wave output from the sensor device are decoded (or interpreted) correctly and such that a system 715 (e.g., MCU 534, ECU, other system) receiving wheel speed information from controller 710 receives accurate information that can be relied upon by the system. For example, in some embodiments, current offset compensation system 720 may detect and compensate for offsets within 20 microseconds of the time at which the analog square wave current signal is received. In some embodiments, current offset compensation system 720 may detect and compensate for offsets within 10.75 microseconds of the time at which the analog square wave current signal is received.

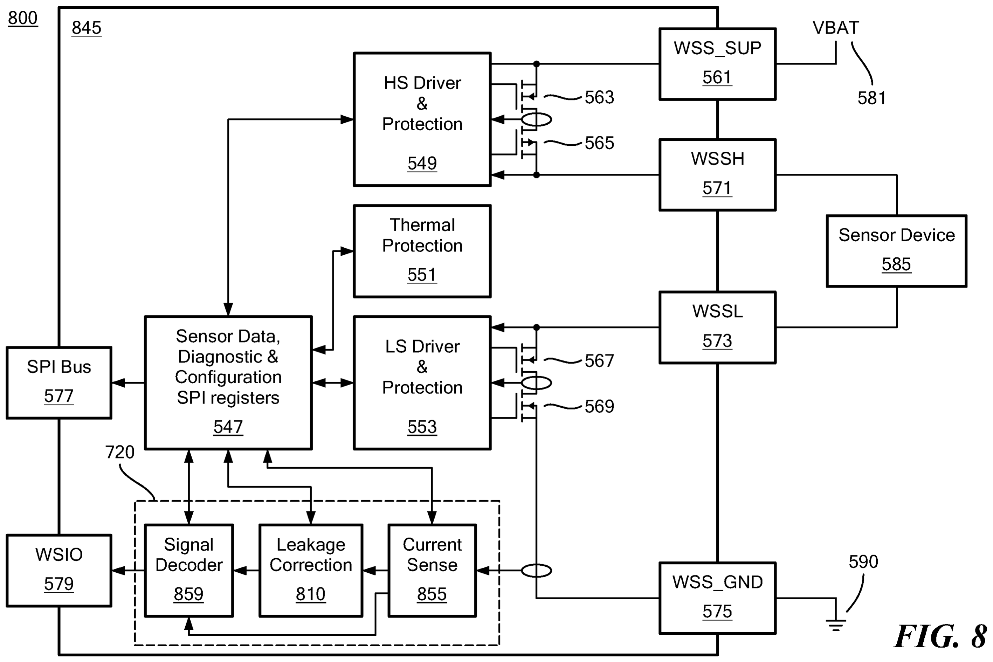

FIG. 8 shows a diagram of another example system 800 for detecting and compensating for an offset of an output received from a sensor device. Like system 540 of FIG. 5C, system 800 may include a sensor device and a controller. Sensor device 585, for example, may be the same as sensor device 585 of FIG. 5C (or the same as sensor device 25, sensor device 205, sensor device 273, sensor device 210, sensor device 526, or sensor device 705). Controller 845 may be similar to controller 545, but may include an offset compensation system (e.g., offset compensation system 720) comprising current sense circuitry 855, leakage correction circuitry 810, and signal decoder circuitry 859. That is, like controller 545 of FIG. 5C, controller 845 may comprise a terminal 561 (WSS_SUP) that couples to a power source (e.g., car battery) VBAT 581, a terminal 571 (WSSH) that provides current to sensor device 585, a terminal 573 (WSSL) that receives current from sensor device 585, a terminal 575 (WSS_GND) that couples to ground, a terminal 577 (SPI Bus) for reading values from registers 547, and a terminal 579 (WSIO) for transmitting decoded values of wheel speed information and other information conveyed by the analog square wave current signal output from sensor device 585. Like controller 545 of FIG. 5C, controller 845 may also include HS driver and protection circuitry 549, thermal protection circuitry 551, LS driver and protection circuitry 553, registers 547, and transistors 563, 565, 567, and 559. Current offset compensation system 720 may comprise current sense circuitry 855, leakage correction circuitry 810, and signal decoder circuitry 859, which will be further discussed herein.

Although certain components of controller 845 are illustrated in FIG. 8, the disclosure is not so limited. A controller, such as controller 845, may include more or less components than those shown in FIG. 8. FIG. 8 shows one example of a controller, but the disclosure herein should not be limited to this example.

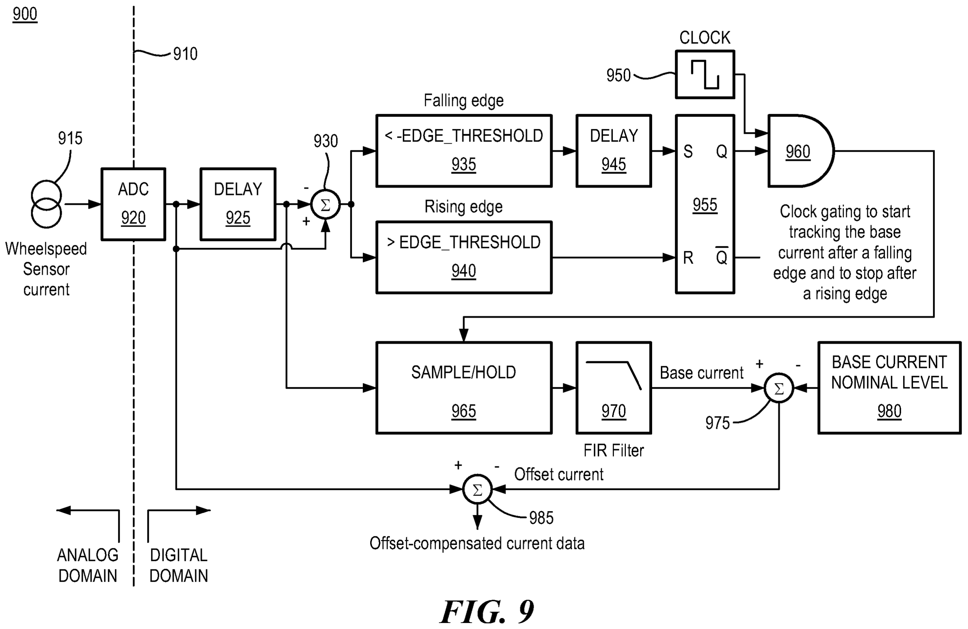

FIG. 9 shows a diagram of an example system 900 for detecting and compensating for an offset of an analog square wave current signal received by a controller (e.g., controller 845). In some embodiments, system 900 may be the same as, or similar to, current offset compensation system 720, with additional details shown, though the disclosure is not so limited.

System 900 may include an analog-to-digital converter (ADC) 920 that receives an analog square wave current signal 915 output from a wheel speed sensor device (e.g., sensor device 25, sensor device 205, sensor device 273, sensor device 210, sensor device 505, sensor device 526, sensor device 585, sensor device 705). As previously discussed the received analog square wave current signal may have an offset due to, for example, a resistive short (see, e.g., FIGs. 6C and 6D and associated discussion). In some embodiments, ADC 920 may be the same as current sense circuitry 855 of system 800, though the disclosure is not so limited. Dotted line 910 illustrates that ADC 920 converts the analog square wave signal (signal in the analog domain) to a digital signal (signal in the digital domain) representing the analog square wave signal.

The digital signal output from ADC 920 may be delayed by delay circuitry 925 for a predetermined period of time. A person of ordinary skill in the art would understand that there are known techniques for implementing delay circuitry, and any of these known techniques should be considered to be within the scope of the disclosure herein. As just one example, delay circuitry (e.g., delay circuitry 925) may be implemented with one or more flip flops. The output of delay circuitry 925 may be output to a subtraction circuitry 930.

Subtraction circuitry 930 may subtract the delayed digital signal received from delay circuitry 925 from the latest (or real-time) digital signal output from ADC 920. The resulting output of subtraction circuitry 930 may be input to comparators 935, 940 for comparison with a predetermined threshold. In some embodiments, the predetermined threshold may be a value of zero. That is, comparators 935, 940 may determine whether the resulting value output from subtraction circuitry 930 is a negative value or a positive value. A negative value (i.e., latest digital signal output from ADC 920 being less than delayed digital signal output from delay circuitry 925) may indicate that a falling edge in the digital version of the square wave output from ADC 920 has occurred, while a positive value (i.e., latest digital signal output from ADC 920 being greater than delayed digital signal output from delay circuitry 925) may indicate that a rising edge in the digital version of the square wave output from ADC 920 has occurred.

When comparator 935 determines that the value output from subtraction circuitry 930 is a negative value (i.e., a falling edge in the digital version of the square wave output from ADC 920 has occurred), a logic high level (e.g., "1") may be output from comparator 935 to delay circuitry 945. When such a determination is not made by comparator 935, a logic low level (e.g., "0") may be output from comparator 935. After some predetermined period of time, delay circuitry 945 may output the value received from comparator 935 to an input set (S) port of a flip flop 955.

When comparator 940 determines that the value output from subtraction circuitry 930 has a positive value (i.e., a rising edge in the digital version of the square wave output from ADC 920 has occurred), a logic high level (e.g., "1") may be output from comparator 940 to a reset (R) input of flip flop 955. When such a determination is not made by comparator 940, a logic low level (e.g., "0") may be output from comparator 940 to the reset (R) input of flip flop 955.

When flip flop 955 receives a logic low level (e.g., "0") as an input to its set (S) port (indicating a falling edge has not occurred) and a logic low level (e.g., "0") as an input to its reset (R) port (indicating a rising edge has not occurred), the value of "0" may be stored in flip flop 955 and output from the Q port of flip flop 955 to AND gate 960.

When flip flop 955 receives a logic high level (e.g., "1") as an input to its set (S) port (indicating a falling edge has occurred) and a logic low level (e.g., "0") as an input to its reset (R) port (indicating a rising edge has not occurred), the value of "1" may be stored in flip flop 955 and output from the Q port of flip flop 955 to AND gate 960.

When flip flop 955 receives a logic high level (e.g., "1") as an input to its reset (R) port (indicating a rising edge has occurred), flip flop 955 may be reset such that a value of "0" it output from the Q port of flip flop 955 to AND gate 960 (until the input to R port returns to a "0" and the input to S port returns to a "1").

The output from port Q of flip flop 955 may be received at an input of AND gate 960. A clock signal 950 from a clock generated in the controller (e.g., controller 710, controller 845) may also be received at another input of AND gate 960. An output of AND gate 960 may be input to an enable port of sample and hold circuitry 965. Sample and hold circuitry 965 may also receive the delayed digital signal output from delay circuitry 925. When the output of AND gate 960 is at a logic high level (e.g., "1"), sampling in sample and hold circuitry 965 may be enabled, and a value of the delayed digital signal may be stored and output from sample and hold circuitry 965. When the output of AND gate 960 is at a logic low level (e.g., "0"), sampling in sample and hold circuitry 965 may be disabled, and the last value sampled may be held in sample and hold circuitry 965 and output from sample and hold circuitry 965.

Thus, it should be appreciated that delay circuitry 925, subtraction circuitry 930, comparator 935, comparator 940, delay circuitry 945, flip flop 955, and AND gate 960 together function to gate the clock that enables sampling by sample and hold circuitry 965 of the delayed digital signal output by delay circuitry 925. That is, when a falling edge has been detected (as determined by comparator 935), a logic high level (e.g., "1") may be passed through delay circuitry 945 and flip flop 955 to enable output of clock signal 950 through AND gate 960, thereby enabling sampling in sample and hold circuitry 965. Thus, a base level of delayed digital signal (representing a base level of current of the analog square wave output from the sensor device) may be sampled after a falling edge has been detected. For example, a base level may correspond to the lowest current level of the analog square wave current signal (e.g., 7 mA plus or minus some offset as discussed above). When a rising edge has been detected (as determined by comparator 940), a logic high level (e.g., "1") may be passed to reset (R) port of flip flop 955, thereby resetting flip flop 955 such that a logic low level (e.g., "0") is output from the Q port of flip flop 955 to AND gate 960, thereby disabling the sampling of sample and hold circuitry 965. Thus, a last sampled base level of delayed digital signal may be held and output by sample and hold circuitry 965 after a rising edge has been detected.

In this way, a base level of current of the analog square wave signal received from the sensor device may be detected continuously over time as the analog square wave current signal is received by the controller (e.g., controller 710, controller 845).

A filter circuitry 970 (shown in FIG. 9 as a finite impulse response (FIR) filter) may receive the signal output from sample and hold circuitry 965 and may filter the received signal to remove spurious (or noisy) components that may result from the transitions between levels of the square wave. Although a FIR filter is shown in FIG. 9, a person of ordinary skill in the art would recognize that other known types of filters may be used to remove noisy or spurious components of the signal output from sample and hold circuitry 965, and the disclosure herein should be considered to encompass these other known types of filters.

The filtered signal output from filter circuitry 970 may therefore be representative of a base current level of the analog square wave current signal (plus or minus some offset due to, for example, a resistive short) received by the controller over time. Subtraction circuitry 975 may receive this filtered signal and subtract from it an expected level of base current 980 (labeled in FIG. 9 as "base current nominal level") to determine an amount of offset current in the received analog square wave signal due to, for example, a resistive short (as discussed above with respect to FIGs. 6C and 6D). The amount of offset current determined by subtraction circuitry may then be input to subtraction circuitry 985.

Subtraction circuitry 985 may subtract the determined amount of offset current from the digital signal output from ADC 920, thereby providing a signal representative of the current that is compensated for the offset (labeled in FIG. 9 as "offset-compensated current data"). The offset-compensated current data may then be output from subtraction circuitry 985.

In some embodiments, delay circuitry 925, subtraction circuitry 930, comparator 935, comparator 940, delay circuitry 945, flip flop 955, AND gate 960, sample and hold circuitry 965, filter 970, subtraction circuitry 975, and subtraction circuitry 985 may together comprise leakage correction circuitry 810 of system 800 of FIG. 8, though the disclosure is not so limited.

The offset-compensated current value output from subtraction circuitry 985 may be input to circuitry for determining the level to which the offset-compensated current data corresponds at a given time. For example, as previously discussed, for a two level current signal, this circuitry may comprise comparators or comparators and hysteresis circuitry for determining whether the offset-compensated current data at a given time corresponds to a speed pulse (e.g., 14 mA of current) or not (e.g., 7 mA of current). As another example, as previously discussed, for a three level current signal using AK protocol, this circuitry may comprise comparators or comparators and hysteresis circuitry for determining whether the offset-compensated current data at a given time corresponds to a speed pulse (e.g., 28 mA of current), a "1" (e.g., 14 mA of current), or a "0" (e.g., 7 mA of current). In some embodiments, the circuitry for determining the level to which the offset-compensated current data corresponds at a given time may be the same as signal decoder circuitry 859 of system 800 of FIG. 8, though the disclosure is not so limited.

The offset amount of current received by the controller will typically be substantially the same regardless of the level of current being output by the sensor device. That is, the base current level (e.g., 7 mA of current) and the higher current levels (e.g., 14 mA of current, 28 mA of current) will typically all be raised or lowered by the same amount of offset. Thus, by determining an offset from the expected base level of current in system 900, the offset can be applied to any level of the received current signal to provide an accurate offset-compensated current value to the circuitry (e.g., signal decoder circuitry 859) that determines the levels at a given time.

System 900 may operate to adjust very quickly for offsets in a received current signal by a controller. As shown in FIG. 9, the digital signal output from ADC 920 is input directly to subtraction circuitry 985, where the previously determined offset is subtracted from the latest digital signal output from ADC 920 to output the offset-compensated current data. Thus, there is very little delay in the signal path of the current signal received by the controller before the levels of the current signal are determined (e.g., by signal decoder circuitry 859).

Delay circuitry 945 in system 900 may serve to delay the sampling of the delayed digital signal by sample and hold circuitry 965 for some period of time to ensure that the base current level of the delayed digital signal has settled before it is sampled. By contrast, there may not be any delay circuitry in the signal path from comparator 940 to flip flop 955, so that sample and hold circuitry 965 immediately stops sampling the delayed digital signal as soon as a rising edge is detected. Immediately stopping the sampling of the delayed digital signal as soon as a rising edge is detected may prevent spurious high current values from being sampled and included in the base current signal output from sample and hold circuitry 965.

A person of ordinary skill in the art would understand how to implement components discussed above in analog and/or digital circuitry. For example, a person of ordinary skill in the art would recognize that there are a variety of techniques for constructing circuitry components such as AND gates, NOT gates, delay circuits, subtraction circuits, summing circuits, sample and hold circuits, comparators, flip flops, filters (e.g., FIR filters) and ADCs. Any known technique for constructing these components should be considered to be within the scope of the disclosure herein.

Additionally, although a specific example circuit is illustrated for system 900 of FIG. 9, this circuit is just an example and the disclosure should not be limited to this example. A person of ordinary skill in the art would recognize that equivalent or similar functionality may be achieved with different circuit implementations using known techniques. As just one example, the circuit may be reconfigured such that various circuit components are triggered based on logic low level (e.g., "0") signals rather than based on logic high level (e.g., "1") signals, and the same or similar result achieved. Thus, alternative circuits that achieve the same or similar functionality using known techniques should be considered to be within the scope of the disclosure herein.

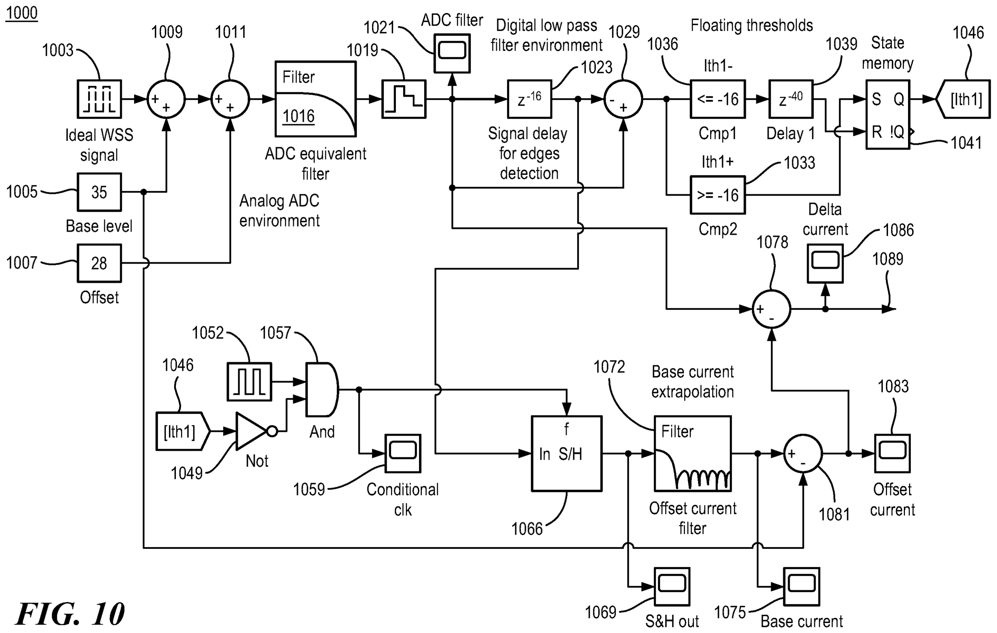

FIG. 10 shows a diagram of an example simulation of a system 1000 for detecting and compensating for an offset of an output received from a sensor device. System 1000 may be, for example, a simulation of system 900.

1003 represents an ideal two-level analog square wave current signal. 1005 represents a base level amount of current (shown in FIG. 10 as "35" mA) for a base level of the two-level square wave current signal. 1009 represents summing ideal two-level square wave current signal 1003 and base level 1005, so that the base level of the two-level square wave current signal is 35 mA. 1007 represents an offset amount of current (shown in FIG. 10 as "28" mA). 1011 represents summing the two-level square wave current signal with the base level with the offset, so that the two-level square wave current signal output from 1011 has a base level of 35 mA and an additional offset of 28 mA.

The signal output from 1011 is then input to a filter 1016 (which as shown in FIG. 10 is a simulated equivalent of an ADC) to output a digital signal 1019 that is a digital version of the two-level square wave signal received from 1011. 1021 represents generating a graph of digital signal 1019 from the ADC.

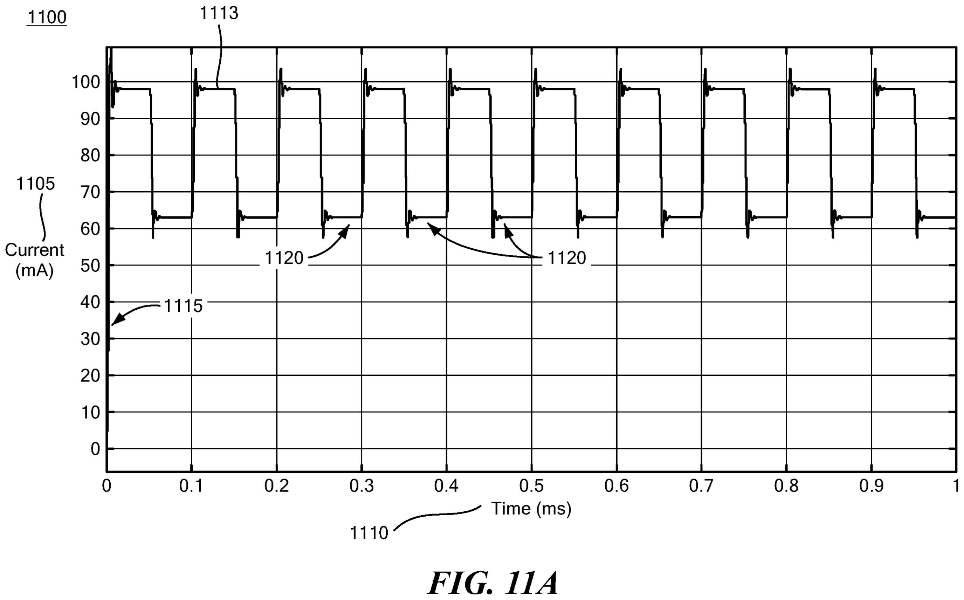

FIG. 11A shows a graph 1100 corresponding to 1021 of FIG. 10. Graph 1100 includes a Y-axis 1105 representing current (e.g., in mA) and an X-axis 1110 representing time (e.g., in ms). Plot 1113 corresponds to digital signal 1019 of FIG. 10. As shown in FIG. 11A, base level 1120 of the two-level square wave current signal is 63 mA (i.e., expected base level 1115 (35 mA) plus offset level of 28 mA).

Referring again to FIG. 10, digital signal 1019 is delayed at delay unit 1023 (e.g., by 16 clock cycles in this example) and the delayed digital signal is output to subtraction unit 1029. Subtraction unit 1029 also receives digital signal 1019. Subtraction unit 1029 subtracts the delayed digital signal (i.e., signal from 1023) from digital signal 1019, and outputs the result to comparator 1036 and comparator 1033.

If the delayed digital signal is less than digital signal 1019 (e.g., subtraction unit 1029 outputs a value above zero), comparator 1033 will output a logic high level (e.g., "1") to set input S of flip flop 1041. Flip flop 1041 will store the value of "1" and will output the value of "1" as current threshold 1 (Ith1) 1046. That value of "1" will then be input to NOT gate 1049, which will output a logic low level (e.g., "0") to AND gate 1057, thereby gating clock 1052 from enabling sample and hold unit 1066.

If the delayed digital signal (i.e., signal from 1023) is greater than digital signal 1019 (e.g., subtraction unit 1029 outputs a value below zero), comparator 1036 will output a logic high level (e.g., "1") to reset input R of flip flop 1041. Flip flop 1041 will then reset to "0" and will store a value of "0" (when the input at S is "0") and will output a value of "0" at the Q port of flip flop 1041 as current threshold 1 (Ith1) 1046 until the output of comparator 1033 is a "1" again. That value of "0" will then be input to NOT gate 1049, which will output a "1" to AND gate 1057, thereby releasing clock 1052 to enable the sampling of sample and hold unit 1066. 1059 represents generating a graph of the gated clock output from AND gate 1057.

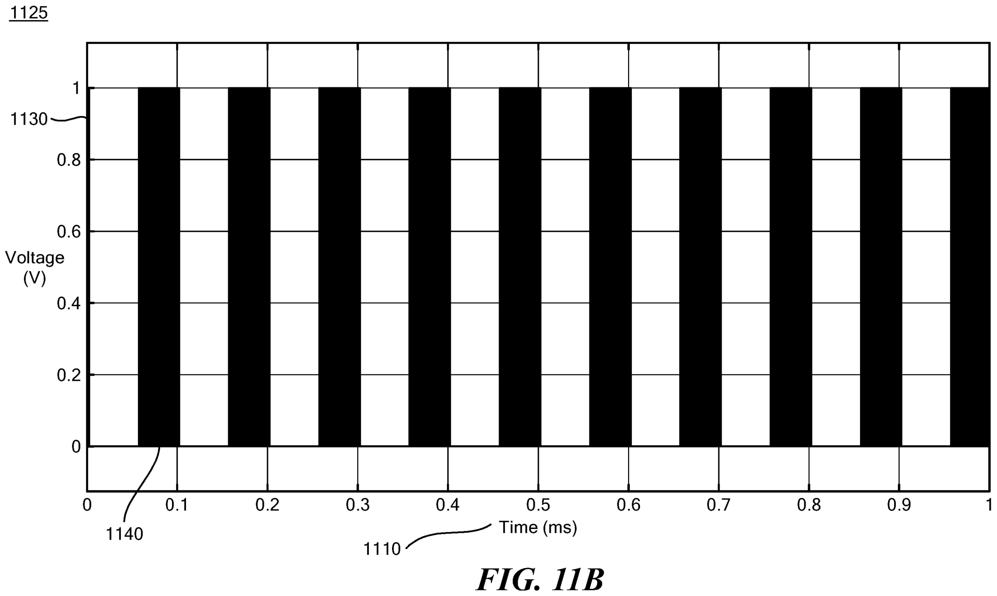

FIG. 11B shows a graph 1125 corresponding to 1059 of FIG. 10. Graph 1125 includes a Y-axis 1130 representing voltage (e.g., in Volts) and an X-axis 1110 representing time (e.g., in ms). Plot 1140 corresponds to the gated clock (labeled in FIG. 10 as "conditional clk") output from AND gate 1057. As can be seen by comparing FIGs. 11A and 11B, the clock is active when the square wave signal shown in FIG. 11A is at its base level, and is inactive when the square wave signal shown in FIG. 11A is not at its base level.

Referring again to FIG. 10, sample and hold unit 1066 receives the delayed digital signal from delay unit 1023. Sampling of sample and hold unit 1066 is controlled by the gated clock output from AND gate 1057. Thus, when the clock signal is received by sample and hold unit 1066 (i.e., when a falling edge has been detected and the square wave is at its base level) the delayed digital signal (i.e., signal from 1023) is sampled by sample and hold unit 1066 at the rate of the clock pulses, and the sampled values are output to a filter unit 1072. When the clock signal is blocked by AND gate 1057 (i.e., when a rising edge has been detected and the square wave is no longer at its base level) and thus is not received by sample and hold unit 1066, the last sampled delayed digital signal value is held and output to filter unit 1072. 1069 represents generating a graph of the signal output from sample and hold unit 1066.

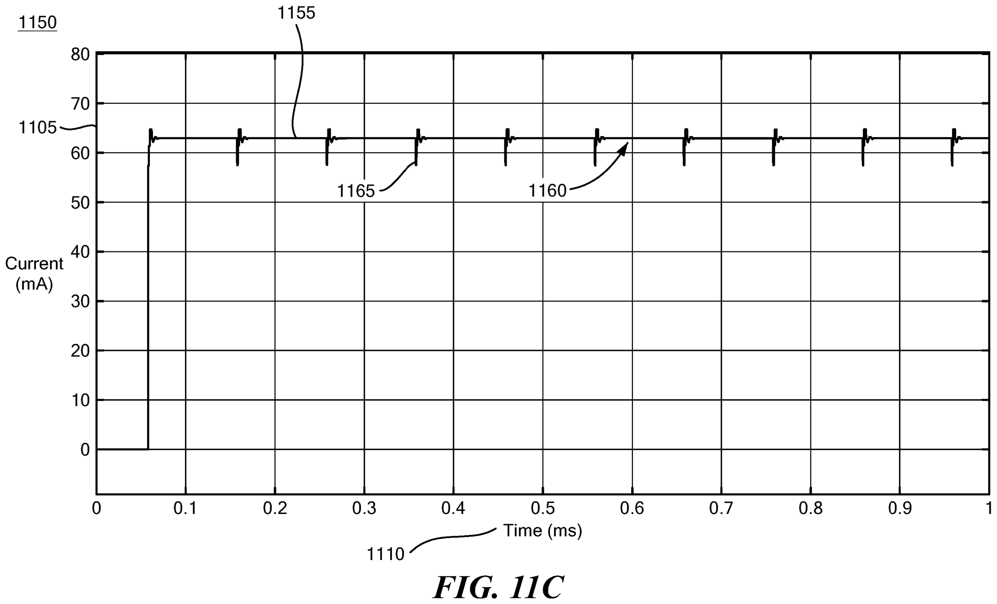

FIG. 11C shows a graph 1150 corresponding to 1069 of FIG. 10. Graph 1150 includes a Y-axis 1105 representing current (e.g., in mA) and an X-axis 1110 representing time (e.g., in ms). Plot 1155 corresponds to the signal output from sample and hold unit 1066 (labeled in FIG. 10 as "S&H out"). As can be seen by comparing FIGs. 11A, 11B, and 11C, the base level of the delayed digital signal (square wave signal) is sampled and held, such that a value of 63 mA 1160 is output (35 mA for the base level (see 1005 of FIG. 10) and 28 mA for the offset (see 1007 of FIG. 10)). As shown in FIG. 11C, sample and hold unit 1066 holds the last sampled value when the clock signal is no longer received (e.g., when a rising edge of the square wave signal has been detected), such that a signal representing just the base level over time is output from sample and hold unit 1066. As shown in FIG. 11C, transitions in the delayed digital signal (square wave signal) may still cause spurious or noisy components (e.g., 1165) to exist in this signal from sample and hold unit 1066, but these spurious or noisy components can be filtered out by filter unit 1072 to provide a smooth signal representing the base level of current over time. The filtered base level of current signal is output to a subtraction unit 1081.

Referring again to FIG. 10, the filtered base level of current signal is output to a subtraction unit 1081. Subtraction unit 1081 subtracts the expected base level of current (e.g., 35 mA) from the filtered base level of current output from filter 1072 (e.g., 63 mA) and the result is output as the determined amount of offset current in the received square wave current signal (e.g., 63 mA - 35 mA = 28 mA, as shown in 1007).

A subtraction unit 1078 subtracts the determined amount of offset current from the digital signal (square wave signal) output by filter 1016 (e.g., ADC) to output a signal 1089 representing the offset-compensated current level of the received square wave signal. That is, signal 1089 represents the current levels of the signal output by the sensor device, with any offsets created by, for example, resistive shorts, removed. 1086 represents generating a graph of the signal output from subtraction unit 1078.

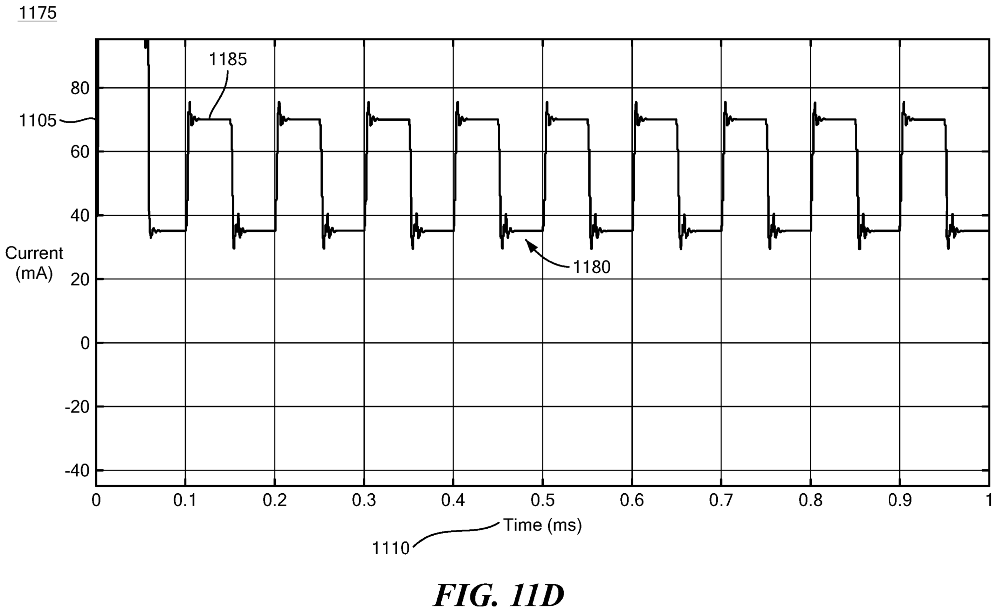

FIG. 11D shows a graph 1175 corresponding to 1086 of FIG. 10. Graph 1175 includes a Y-axis 1105 representing current (e.g., in mA) and an X-axis 1110 representing time (e.g., in ms). Plot 1185 corresponds to the signal output from subtraction unit 1078 (labeled in FIG. 10 as "delta current"). As can be seen by comparing FIGs. 11A and 11D, the offset-compensated signal output from subtraction unit 1078 in FIG. 11D now has a base level 1180 of 35 mA, as expected, instead of the base level 1120 of 63 mA as in FIG. 11A. As can also be seen by comparing FIGs. 11A and 11D, the top level of the square wave signal now has a level of 70 mA, as shown in FIG. 11D, down from 98 mA (70 mA + 28 mA offset) of FIG. 11A. Thus, the entire square wave is accurately represented, but has been adjusted to compensate for the offset current.

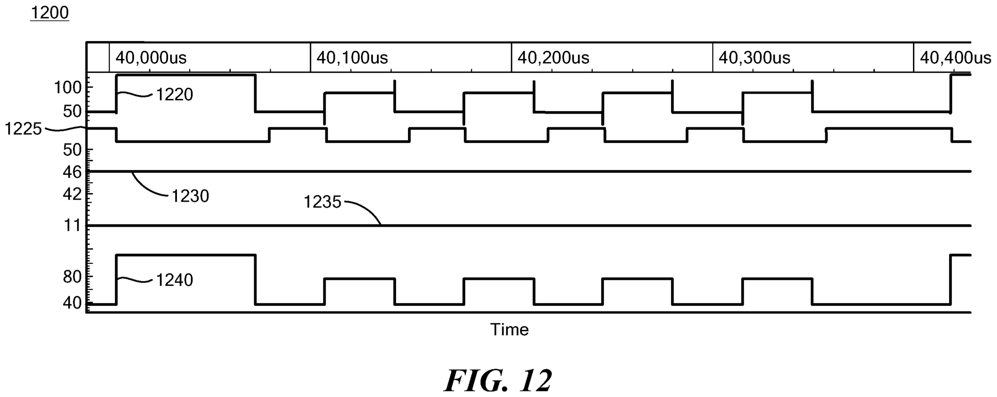

FIG. 12 shows graphs 1200 of another simulation of system 1000 of FIG. 10, with different signals shown simultaneously in FIG. 12. In the example simulation generating the graphs of FIG. 12, ideal WSS signal (e.g., 1003) was a three-level analog square wave signal, the base level of current (e.g., 1005 of FIG. 10) was again set to 35 mA, and the offset amount of current (e.g., 1007 of FIG. 10) was set to 11 mA. The Y-axes of graphs 1200 represent current (e.g., in mA) and the X-axes of graphs 1200 represent time (e.g., in microseconds (µs)). Plot 1220 corresponds to signal 1019 output from filter 1016 (e.g., ADC) of FIG. 10. That is, the graph of plot 1220 may correspond to 1021 of FIG. 10. In the example of FIG. 12, the received signal is a three level square wave, with a first pulse corresponding to speed, and remaining current levels corresponding to "0" or "1" values. For example, the signal plotted in 1220 may correspond to an AK protocol square wave signal output from a sensor device. The base level of the signal plotted in 1220 is 46 mA (i.e., 35 mA of base level current plus 11 mA of offset current) in FIG. 12.

Plot 1225 corresponds to the output of AND gate 1057 of FIG. 10. That is, the graph of plot 1225 may correspond to 1059 of FIG. 10. As shown in plot 1225, sampling by sample and hold unit 1066 is enabled after some delay period of time (e.g., 16 clock cycles) after a falling edge of the square wave signal output from filter 1016 (e.g., ADC) has been detected. This delay allows the base current level to stabilize after the falling edge transition before the base current level is sampled. As shown in plot 1225, sampling by sample and hold unit 1066 is stopped as soon as a rising edge of the square wave signal output from filter 1016 (e.g., ADC) has been detected, to prevent sampling of any higher level current values.

Plot 1230 corresponds to the sampled base level current after it has been filtered to remove spurious and/or noisy components. For example, plot 1230 may represent the signal output from filter unit 1072 (e.g., FIR filter). That is, the graph of plot 1230 may correspond to 1075 of FIG. 10. As shown in plot 1230, a smooth signal representing a base level of current of 46 mA may be output.

Plot 1235 corresponds to the determined amount of offset current. For example, plot 1235 may represent the signal output from subtraction unit 1081 of FIG. 10. That is, the graph of plot 1235 may correspond to 1083 of FIG. 10. As shown in plot 1235, a smooth signal representing an offset amount of current of 11 mA (i.e., 46 mA (sampled base level current) - 35 mA (expected amount of base level current)) may be output.

Plot 1240 corresponds to the offset-compensated amount of current. For example, plot 1240 may represent the signal output from subtraction unit 1078 as signal 1089 of FIG. 10. That is, the graph of plot 1240 may correspond to 1086 of FIG. 10. As can be seen by comparing plots 1220 and 1240, plot 1240 now has a base level of 35 mA, as expected, instead of the base level of 46 mA as in plot 1220. Thus, the entire square wave is accurately represented, and has been shifted to compensate for the 11 mA of offset.

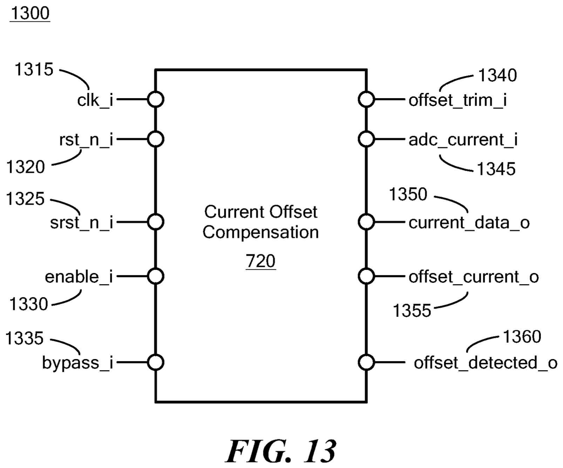

FIG. 13 shows a block diagram of an example system 1300 for detecting and compensating for an offset of a signal received from a sensor device, with inputs and output of the example system shown. For example, system 1300 may correspond to a system, such as current offset compensation system 720 of FIGs. 7-10. FIG. 13 illustrates various example inputs and outputs of such a current offset compensation system.

For example, 1315 represents a port (represented in FIG. 13 as "clk_i") for inputting a clock signal to current offset compensation system 720. The clock signal may be, for example, clock signal 950 of FIG. 9 and/or clock signal 1052 of FIG. 10, for example. In some embodiments, the clock signal may be an eight megahertz (8 MHz) system clock generating elsewhere in the controller (e.g., controller 710, controller 845), though the disclosure is not so limited. In some embodiments, port 1315 may be a one bit interface, such that "1s" and "0s" are sent to port 1315 at a particular frequency (8 MHz) to serve as the clock for current offset compensation system 720, though the disclosure is not so limited.

1320 represents a port (represented in FIG. 13 as "rst_n_i") for inputting an asynchronous reset signal to current offset compensation system 720. For example, an asynchronous reset signal may be sent from elsewhere in the controller (e.g., controller 710, controller 845) or from an external system (e.g., MCU 534, an ECU) to current offset compensation system 720 at any time to reset the components and stored values of current offset compensation system 720. In some embodiments, port 1320 may be a one bit interface, such that a signal representing a "1" may reset current offset compensation system 720, while a signal representing a "0" would not, though the disclosure is not so limited.

1325 represents a port (represented in FIG. 13 as "srst_n_i") for inputting a synchronous reset signal to current offset compensation system 720. For example, a synchronous reset signal may be sent from elsewhere in the controller (e.g., controller 710, controller 845) or from an external system (e.g., MCU 534, an ECU) to current offset compensation system 720 at some time that is synchronized with the clock signal or with some other signal of the controller (e.g., controller 710, controller 845) or of the external system to reset the components and stored values of current offset compensation system 720. In some embodiments, port 1325 may be a one bit interface, such that a signal representing a "1" may reset current offset compensation system 720, while a signal representing a "0" would not, though the disclosure is not so limited.

1330 represents a port (represented in FIG. 13 as "enable_i") for inputting a clock enable signal to current offset compensation system 720. For example, a clock enable signal may be sent from elsewhere in the controller (e.g., controller 710, controller 845) or from an external system (e.g., MCU 534, an ECU) to current offset compensation system 720 to enable or disable current offset compensation system 720 (e.g., by enabling or disabling use of the clock signal input at port 1315). In some embodiments, port 1330 may be a one bit interface, such that a signal representing a "1" may cause the current offset compensation system to be enabled, while a signal representing a "0" may cause the current offset compensation system to be disabled, though the disclosure is not so limited.

1335 represents a port (represented in FIG. 13 as "bypass_i") for inputting a signal that causes the internal current compensation of current offset compensation system 720 to be bypassed. For example, a bypass signal may be sent from elsewhere in the controller (e.g., controller 710, controller 845) or from an external system (e.g., MCU 534, an ECU) to current offset compensation system 720 to cause current offset compensation system 720 to bypass its offset compensation algorithm/components. That is, the signal may cause offset compensation system 720 to send the square wave signal converted by the ADC (e.g., current sense circuitry 855) to level determining circuitry (e.g., signal decoder circuitry 859) without compensating for any offsets in the square wave signal. In some embodiments, port 1335 may be a one bit interface, such that a signal representing a "1" may cause the current offset compensation algorithm/components of current offset compensation system 720 to be bypassed, while a signal representing a "0" may cause received current signals to be passed through the current offset compensation algorithm/components of current offset compensation system 720, though the disclosure is not so limited.

1340 represents a port (represented in FIG. 13 as "offset_trim_i") for trimming the offset of current offset compensation system 720. For example, an offset trim signal may be sent from elsewhere in the controller (e.g., controller 710, controller 845) or from an external system (e.g., MCU 534, an ECU) to current offset compensation system 720 to adjust the amount of offset current determined by current offset compensation system 720. In some embodiments, an external system (e.g., MCU 534, an ECU) may send an instruction to trim the offset of current offset compensation system 720 over an interface (e.g., SPI bus 577) to one or more input registers 547 of the controller (e.g., controller 710, controller 845), and the input register value(s) may be output to port 1340 of current offset compensation system 720. That is, the amount of offset current determined by subtraction circuitry 975 of system 900, or by subtraction unit 1081 of system 1000, may be adjusted by an amount indicated by the offset trim signal. In some embodiments, port 1340 may be a signed six bit interface, and the six bits received at port 1340 may represent a positive or negative amount value by which to trim the offset of current offset compensation system 720, though the disclosure is not so limited.

In discussing FIGs. 8, 9, and 10 above, the ADC receiving the analog square wave signal was sometimes discussed as being part of current offset compensation system 720. In some embodiments, the ADC may be external to current offset compensation system 720, and the signal from the ADC may be received at 1345. That is, 1345 represents a port (represented in FIG. 13 as "adc _current_i") for inputting the digital current signal from the ADC to current offset compensation system 720. For example, the digital current signal input into port 1345 may correspond to the digital signal output from ADC 920 of FIG. 9 or from filter 1016 (e.g., ADC) of FIG. 10, though the disclosure is not so limited. In some embodiments, port 1345 may be an unsigned eight bit interface, and the eight bits received at port 1345 may represent a positive amount of current of the analog square wave signal received by the ADC at any given time, though the disclosure is not so limited.

In discussing FIGs. 8, 9, and 10 above, the level determining circuitry (e.g., signal decoder circuitry 859) was sometimes discussed as being part of current offset compensation system 720. In some embodiments, the level determining circuitry may be external to current offset compensation system 720, and the offset-compensated amount of current may be output at 1350. That is, 1350 represents a port (represented in FIG. 13 as "current_data_o") for outputting the offset-compensated amount of current after the offset has been determined and compensated for in current offset compensation system 720. For example, offset-compensated amount of current signal output from port 1350 may correspond to the signal output from subtraction circuitry 985 of FIG. 9, or from subtraction unit 1081 (i.e., signal 1089) of FIG. 10, though the disclosure is not so limited. In some embodiments, port 1350 may be an unsigned eight bit interface, and the eight bits output from port 1350 may represent a positive amount of current of the analog square wave signal received by the ADC, after it has been adjusted for a determined offset, at any given time, though the disclosure is not so limited.

1355 represents a port (represented in FIG. 13 as "offset_current_o") that may output the amount of current offset that was determined and compensated for by current offset compensation system 720. For example, the signal output from port 1355 may correspond to the signal ("offset current") output from subtraction circuitry 975 of FIG. 9 or to the signal ("offset current") output from subtraction unit 1081 of FIG. 10, though the disclosure is not so limited. In some embodiments, port 1355 may be a signed nine bit interface, and the nine bits output from port 1355 may represent a positive or negative amount of offset current determined and compensated for by current offset compensation system 720, though the disclosure is not so limited.

1360 represents a port (represented in FIG. 13 as "offset_detected _o") that may output a logic high level (e.g., "1") if a predetermined threshold level of offset current has been exceeded, and a logic low level (e.g., "0") if the predetermined threshold level of offset current has not been exceeded. For example, a predetermined threshold level may be set in current offset compensation system 720. When an amount of offset current is determined that is greater than the predetermined threshold level (e.g., some large amount such as 20 mA), a logic high level (e.g., "1") signal may be output to one or more other components of the controller (e.g., controller 710, controller 845), such as registers 547, or to one or more external systems (e.g., MCU 534, an ECU). Upon receipt of such a signal, the one or more other components or external systems may determine, for example, that the offset level of current is too high, and that the sensing system should be shut down for diagnostics and/or repairs.

In some embodiments, certain signals (e.g., signal to 1315, signal to 1320, signal to 1325, signal to 1330, signal to 1335, signal to 1340, signal to 1345) input to current offset compensation system 720 may be received from one or more registers 547 of the controller (e.g., controller 710, controller 845). For example, values for these signals may be programmed into register(s) 547 by one or more other components of the controller or by one or more external systems (e.g., MCU 534, an ECU). In some embodiments, certain signals (e.g., signal from 1350, signal from 1355, signal from 1360) may be output to one or more registers 547 of the controller (e.g., controller 710, controller 845). For example, values for these signals may be programmed into register(s) 547 by current offset compensation system 720, and may be then read out of register(s) 547 by one or more other components of the controller, or by one or more external systems (e.g., MCU 534, an ECU).

Although certain example ports of a current offset compensation system 720 were discussed above with respect to FIG. 13, the disclosure is not so limited. Different ports receiving or outputting different information, or a greater or lesser number of input and/or output ports, may be provided for a current offset compensation system 720.

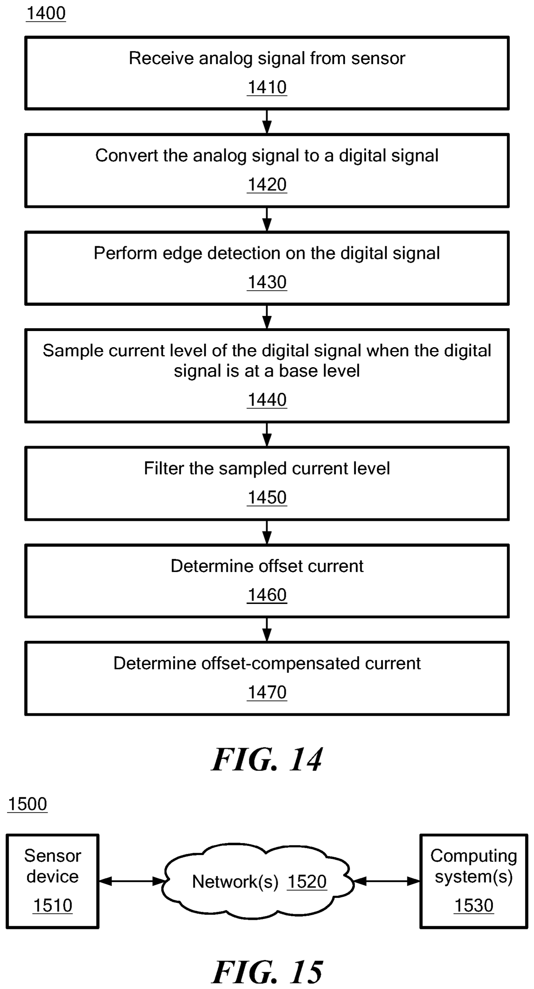

FIG. 14 shows a flow diagram of an example process 1400 for detecting and compensating for an offset of a signal received from a sensor device. Example process 1400 may be implemented by a controller (e.g., controller 710, controller 845), such as a PMIC or some other system (e.g., MCU 534, an ECU). In some embodiments, example process 1400 may be implemented by one or more computing systems (e.g., computing system(s) 1530 of FIG. 15).

Using process 1400, a controller, system, or computing system may automatically determine an amount of offset in a signal received from a sensor device, and may automatically compensate for the determined amount of offset in that signal. In some embodiments, a controller, system, or computing system may automatically and continually determine an amount of offset in a signal received from a sensor device, and may automatically and continually compensate for the determined amount of offset in that signal, with very little delay. In doing so, offsets in a continuously received signal (e.g., continuously received analog square wave signal from a sensor device) can be quickly, automatically, and continually compensated for, providing an accurate representation of the signal output from the sensor device for further processing and/or interpretation.

In 1410, an analog signal may be received from a sensor device (e.g., wheel speed sensor device) (e.g., sensor device 25, sensor device 205, sensor device 273, sensor device 210, sensor device 505, sensor device 526, sensor device 585, sensor device 705). For example, a two-level or three-level analog square wave signal may be received from a sensor device. In some embodiments, as discussed above, the analog square wave signal may be an AK protocol signal or a PWM signal. In some embodiments, different levels of current in the analog square wave signal may represent information from the sensor device, such as pulses indicative of wheel speed and pulses indicative of other information (e.g., air gap, direction of rotation of a target). In some embodiments, the analog signal may be received by an ADC (e.g., ADC 920, filter 1016).

In 1420, the analog signal may be converted to a digital signal. For example, as previously discussed, an ADC (e.g., ADC 920, filter 1016) may convert the analog signal to a digital representation of the analog signal.

In 1430, edge detection may be performed on the digital signal output from the ADC. For example, as discussed above, the digital signal may be delayed (e.g., by delay circuitry 925, delay unit 1023), the delayed digital signal may be subtracted (e.g., by subtraction circuitry 930, subtraction unit 1029) from the most recent digital signal from the ADC, a comparator (e.g., comparator 935, comparator 1036) may determine whether the result of the subtraction indicates a falling edge has occurred in the digital signal, and a comparator (e.g., comparator 940, comparator 1033) may determine whether the result of the subtraction indicates a rising edge has occurred in the digital signal.

In 1440, a level of an amount of current of the digital signal may be sampled when the digital signal is at its base level. For example, as discussed above, if a falling edge has been detected by a comparator, a logic high level (e.g., "1") may be output, and may be delayed (e.g., by delay circuitry 945, delay unit 1039). The delayed logic high level signal may then be input to a flip flop (e.g., flip flop 955, flip flop 1041), and an output of that flip flop may cause an AND gate (e.g., AND gate 960, AND gate 1057) to release a clock signal (e.g., clock signal 950, clock signal 1052) that enables sampling (e.g., by sample and hold circuitry 965, by sample and hold unit 1066) of the level of current of the delayed digital signal. As previously discussed, when a rising edge of the digital signal is detected, sampling of the digital signal may stop and the last sampled level of the digital signal may be held (e.g., by sample and hold circuitry 965, by sample and hold unit 1066) until another falling edge is detected.

In 1450, the sampled level of current of the digital signal may be filtered. For example, as previously discussed, the sampled signal (e.g., signal from sample and hold circuitry 965, signal from sample and hold unit 1066) may be input to a filter (e.g., FIR filter) (e.g., filter circuitry 970, filter unit 1072) to remove spurious signals and/or noise from the signal.

In 1460, an amount of offset current may be determined. For example, as previously discussed, a difference between the sampled amount of base current and an expected amount of base current may be determined (e.g., by subtraction circuitry 975, subtraction unit 1081).

In 1470, an amount of offset-compensated current may be determined. For example, as previously discussed, a difference can be taken (e.g., by subtraction circuitry 985, by subtraction unit 1078) between the amount of current indicated by the digital signal received from the ADC and the amount of offset current determined in 1460 to determine an amount of offset-compensated current. This amount of offset-compensated current may then be sent to level determining circuitry (e.g., signal decoder circuitry 859), which may determine which level the current corresponds to in order to decode information (e.g., whether the offset-compensated current corresponds to a speed pulse, or a "1" or a "0" associated with a particular bit of information in the analog square wave output from the sensor device).

Process 1400 may be performed continuously and in real-time, such that a controller (e.g., controller 710, 845) or other system or computing system implementing process 1400 may detect and compensate for offsets in received analog square wave signals over time as a sensor device operates.

FIG. 15 is a block diagram of an example computing environment for implementing embodiments of the present disclosure, in accordance with some embodiments. For example, all or part of process 1400 may be implemented in one or more computing systems 1530 connected to a sensor device 1510 over one or more networks 1520. For example, one or more computing systems 1530 may receive one or more signals, data, or other communications from sensor device 1510, and may then perform some or all of the tasks of process 1400. For example, computing system(s) 1530 may receive a signal output from a sensor device, or a digital version of a signal output from a sensor device (e.g., as converted by an ADC), and may perform edge detection on the signal, sample a current level of the signal when the signal is at a base level, filter the sampled current level, determine an amount of offset current in the signal, and determine an offset-compensated amount of current of the signal. The arrangement and number of components in computing environment 1500 is provided for purposes of illustration. Additional arrangements, numbers of components, and other modifications may be made, consistent with the present disclosure.

As shown in FIG. 15, the computing environment may include a sensor device 1510. Sensor device 1510 may, for example, be a sensor device as previously described (e.g., sensor device 25, sensor device 205, sensor device 273, sensor device 210, sensor device 505, sensor device 526, sensor device 585, or sensor device 705). Sensor device 1510 may be coupled to one or more computing systems 1530 over one or more networks 1520. Sensor device 1510 may communicate signals, such as signals received from and/or derived from one or more magnetic field sensing elements, to a computing system 1530 over the one or more networks 1520. The signals may, for example, be a square wave current signal, such as a two-level or three-level square wave current signal. In some embodiments, the square wave current signal may be an AK protocol signal or a PWM signal. In some embodiments, the square wave current signal may convey information such as rotation speed, rotation direction, vibration, air gap, or any other information generated by a sensor device.

Network(s) 1520 may include, for example, one or more wired and/or wireless networks. By way of example, network(s) 1520 may include a conductor over which current or voltage signals may be transmitted, an Inter-Integrated Circuit (I²C) network, a Controller Area Network (CAN) network, a WiFi network, an Ethernet network, a Universal Serial Bus (USB) network, a local area network (LAN) network, a PCI Express network, an SPI network, a UART/USART network, a cellular network (e.g., 5G network), and/or any other suitable type of network. Network(s) may be wired, wireless, or a combination of wired and wireless interfaces. In some embodiments, network(s) may be one or more conductors over which sensor device 1510 sends analog and/or digital pulses representing information about the rotating target.

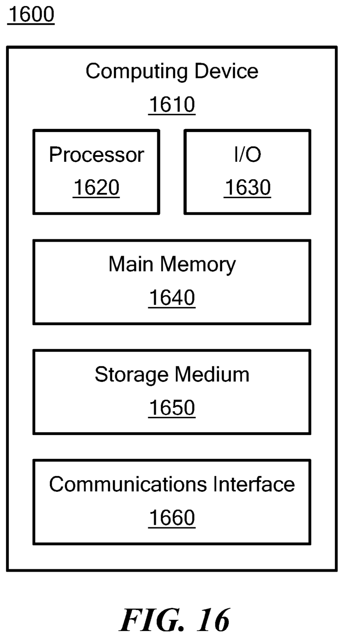

Computing system(s) 1530 may include one or more computing devices (see, e.g., computing device 1610 of FIG. 16). A computing device may be, for example, a computing device that may be used to perform some or all of process 1400 of FIG. 14. A computing device 1610 may be, for example, an integrated circuit connected to a sensor device. Alternatively, a computing device 1610 may be a computer, such as a laptop computer, mobile phone, tablet, personal computer, server computer, or other type of computer.

FIG. 16 is a block diagram 1600 of an example computing device 1610, consistent with embodiments of the present disclosure. Computing device 1610 may, for example, perform part of all of process 1400 of FIG. 14 based on signals received over one or more networks (e.g., network(s) 1520) from a sensor device (e.g., sensor device 1510). As shown in FIG. 16, a computing device 1610 may include one or more processors or controllers 1620 for executing instructions. Processors or controllers suitable for the execution of instructions may include, by way of example, both general and special purpose (e.g., application specific integrated circuit (ASIC)) processors or controllers. A computing device 1610 may also include one or more input/output (I/O) devices 1630. By way of example, I/O devices 1630 may include keys, buttons, mice, joysticks, styluses, etc. Keys and/or buttons may be physical and/or virtual (e.g., provided on a touch screen interface). A computing device 1610 may be connected to one or more displays (not shown) via I/O 1630. A display may be implemented using one or more display panels, which may include, for example, one or more cathode ray tube (CRT) displays, liquid crystal displays (LCDs), plasma displays, light emitting diode (LED) displays, touch screen type displays, organic light emitting diode (OLED) displays, or any other type of suitable display.

A computing device 1610 may include one or more storage devices configured to store data and/or software instructions used by processor(s) or controller(s) 1620 to perform operations consistent with disclosed embodiments. For example, computing device 1610 may include main memory 1640 configured to store one or more software programs that, when executed by processor(s) or controller(s) 1620, cause processor(s) or controller(s) 1620 to perform functions or operations consistent with disclosed embodiments.

By way of example, main memory 1640 may include NOR and/or NAND flash memory devices, read only memory (ROM) devices, random access memory (RAM) devices, etc. A computing device 1610 may also include one or more storage mediums 1650. By way of example, storage medium(s) 1650 may include hard drives, solid state drives, etc. A computing device 1610 may include any number of main memories 1640 and storage mediums 1650. A main memory 1640 or storage medium 1650 may, in some embodiments, be a non-transitory computer-readable medium.

A computing device 1610 may further include one or more communication interfaces 1660. Communication interface(s) 1660 may allow one or more signals to be received from a sensor device (e.g., sensor device 1510) over one or more networks 1520, and may allow one or more signals to be transmitted to the sensor device. Example communication interface(s) 1660 include a modem, network interface card (e.g., Ethernet card), communications port, antenna, conductor over which current or voltage signals may be transmitted, an Inter-Integrated Circuit (I²C) interface, a Controller Area Network (CAN) network interface, a WiFi interface, an Ethernet a Universal Serial Bus (USB) interface, a local area network (LAN) network interface, a PCI Express card, an SPI interface, a UART/USART interface, a cellular (e.g., 5G) interface, and/or any other suitable type of interface for transmitting and/or receiving signals or other information. Communication interface(s) 1660 may transmit software, data, or information in the form of signals, which may be electronic, electromagnetic, optical, and/or other types of signals. The signals may be provided to/from communications interface 1660 via a communications path (e.g., network(s) 1520), which may be implemented using wired, wireless, cable, fiber optic, radio frequency (RF), and/or other communications channels.

Although embodiments are described herein for applications where an analog square wave signal is received from a sensor device, the disclosure is not so limited. A person of ordinary skill in the art would recognize that the examples described herein for detecting and compensating for current offsets in square wave signals may be used in any application involving square wave signals, and the disclosure should be interpreted as encompassing use of the examples described herein in any of these applications. Additionally, the examples described herein for detecting and compensating for current offsets may be implemented in a standalone system (e.g., system 900, system 1000) or as part of any larger system (e.g., controller 710, PMIC, ECU, system 715), and the disclosure should be interpreted as encompassing implementation of the examples in any of these ways.

As used herein, the term "processor" or "controller" is used to describe electronic circuitry that performs a function, an operation, or a sequence of operations. The function, operation, or sequence of operations can be hard coded into the electronic circuit or soft coded by way of instructions held in a memory device. The function, operation, or sequence of operations can be performed using digital values or using analog signals. In some embodiments, the processor or controller can be embodied in an application specific integrated circuit (ASIC), which can be an analog ASIC or a digital ASIC, in a microprocessor with associated program memory and/or in a discrete electronic circuit, which can be analog or digital. A processor or controller can contain internal processors or modules that perform portions of the function, operation, or sequence of operations. Similarly, a module can contain internal processors or internal modules that perform portions of the function, operation, or sequence of operations of the module.

While electronic circuits shown in figures herein may be shown in the form of analog blocks or digital blocks, it will be understood that the analog blocks can be replaced by digital blocks that perform the same or similar functions and the digital blocks can be replaced by analog blocks that perform the same or similar functions. Analog-to-digital or digital-to-analog conversions may not be explicitly shown in the figures but should be understood.

Various embodiments of the systems, methods, and techniques are described herein with reference to the related drawings. Alternative embodiments can be devised without departing from the scope of the described concepts. It is noted that various connections and positional relationships (e.g., over, below, adjacent, etc.) are set forth between elements in the following description and in the drawings. These connections and/or positional relationships, unless specified otherwise, can be direct or indirect, and the present invention is not intended to be limiting in this respect. Accordingly, a coupling of entities can refer to either a direct or an indirect coupling, and a positional relationship between entities can be a direct or indirect positional relationship. As an example of an indirect positional relationship, references in the present description to element or structure A over element or structure B include situations in which one or more intermediate elements or structures (e.g., element C) is between elements A and B regardless of whether the characteristics and functionalities of elements A and/or B are substantially changed by the intermediate element(s).

Furthermore, it should be appreciated that relative, directional or reference terms (e.g. such as "above," "below," "left," "right," "top," "bottom," "vertical," "horizontal", "front," "back," "rearward," "forward," etc.) and derivatives thereof are used only to promote clarity in the description of the figures. Such terms are not intended as, and should not be construed as, limiting. Such terms may simply be used to facilitate discussion of the drawings and may be used, where applicable, to promote clarity of description when dealing with relative relationships, particularly with respect to the illustrated embodiments. Such terms are not, however, intended to imply absolute relationships, positions, and/or orientations. For example, with respect to an object or structure, an "upper" or "top" surface can become a "lower" or "bottom" surface simply by turning the object over. Nevertheless, it is still the same surface and the object remains the same. Also, as used herein, "and/or" means "and" or "or," as well as "and" and "or." Moreover, all patent and non-patent literature cited herein is hereby incorporated by references in their entirety.

The terms "disposed over," "overlying," "atop," "on top," "positioned on" or "positioned atop" mean that a first element, such as a first structure, is present on a second element, such as a second structure, where intervening elements or structures (such as an interface structure) may or may not be present between the first element and the second element. The term "direct contact" means that a first element, such as a first structure, and a second element, such as a second structure, are connected without any intermediary elements or structures between the interface of the two elements. The term "connection" can include an indirect connection and a direct connection.

The terms "approximately," "substantially," or "about" may be used to mean within +/- 30% of a target value in some embodiments, within +/- 20% of a target value in some embodiments, within +/- 10% of a target value in some embodiments, within +/- 5% of a target value in some embodiments, and within +/- 2% of a target value in some embodiments. The aforementioned terms may also include the target value.

In the foregoing detailed description, various features are grouped together in one or more individual embodiments for the purpose of streamlining the disclosure. This method of disclosure is not to be interpreted as reflecting an intention that each claim requires more features than are expressly recited therein. Rather, inventive aspects may lie in less than all features of each disclosed embodiment.

References in the disclosure to "one embodiment," "an embodiment," "some embodiments," or variants of such phrases indicate that the embodiment(s) described can include a particular feature, structure, or characteristic, but every embodiment can include the particular feature, structure, or characteristic. Moreover, such phrases are not necessarily referring to the same embodiment(s). Further, when a particular feature, structure, or characteristic is described with reference to one embodiment, knowledge of one skilled in the art may be relied upon to affect such feature, structure, or characteristic in connection with other embodiments whether or not explicitly described.

The disclosed subject matter is not limited in its application to the details of construction and to the arrangements of the components set forth in the following description or illustrated in the drawings. The disclosed subject matter is capable of other embodiments and of being practiced and carried out in various ways. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.

All publications and references cited herein are expressly incorporated herein by reference in their entirety.

## Claims

1. A system, comprising:
an analog-to-digital converter (ADC) configured to:
receive an analog square wave signal; and
output a digital signal representing the analog square wave signal; and circuitry configured to:
identify a transition in the digital signal to a base current level;
sample the base current level of the digital signal; and
determine an amount of offset current based on a difference between the sampled base current level and a predetermined current level.

2. The system of claim 1, wherein the analog square wave signal is received from a sensor device.

3. The system of claim 1, wherein the circuitry is further configured to:
adjust the digital signal by the amount of the offset current; and
output the adjusted digital signal.

4. The system of claim 1, wherein the circuitry is further configured to output information about the determined amount of the offset current.

5. The system of claim 1, wherein the circuitry is further configured to:
delay the digital signal;
compare a level of the delayed digital signal with a level of the digital signal to identify the transition; and
sample the base current level of the digital signal by sampling the base current level of the delayed digital signal.

6. The system of claim 5, wherein the transition corresponds to a falling edge of the digital signal.

7. The system of claim 6, wherein the transition is a first transition, and the circuitry is further configured to:
start sampling a current level of the delayed digital signal after the first transition has been identified; and
stop sampling the current level of the delayed digital signal when a second transition has been identified, the second transition corresponding to a rising edge of the digital signal.

8. The system of claim 1, wherein the circuitry comprises a filter configured to filter the sampled base current level, and wherein the sampled base current level used in determining the amount of offset current is the filtered sampled base current level.

9. The system of claim 8, wherein the filter is a finite impulse response (FIR) filter.

10. The system of claim 1, wherein the analog square wave signal is a square wave with three current levels.

11. The system of claim 1, wherein the analog square wave signal is an AK protocol signal.

12. The system of claim 1, wherein the analog square wave signal is a square wave with two current levels.

13. The system of claim 1, further comprising a memory storing instructions, wherein the circuitry comprises a digital processor that, when executing the instructions, is configured to identify the transition in the digital signal, sample the base current level, and determine the amount of offset current.

14. The system of claim 1, wherein the analog square wave signal comprises a current offset due to a resistive short.

15. The system of claim 2, wherein the sensor device is a magnetic wheel speed sensor device.

16. The system of claim 1, wherein the system is implemented in a power management integrated circuit (PMIC).

17. The system of claim 1, wherein the circuitry is further configured to be programmed to trim the determined amount of offset current.

18. The system of claim 3, wherein the circuitry further comprises hysteresis circuitry, the hysteresis circuitry receiving the adjusted digital signal and identifying that the adjusted digital signal corresponds to one of at least two different current levels.

19. A method, comprising:
identifying a transition in a digital signal to a base current level;
sampling the base current level of the digital signal; and
determining an amount of offset current based on a difference between the sampled base current level and a predetermined current level.

20. The method of claim 19, further comprising:
adjusting the digital signal by the amount of the offset current; and
outputting the adjusted digital signal.

21. The method of claim 19, further comprising outputting information about the determined amount of the offset current.

22. The method of claim 19, wherein the transition is a first transition corresponding to a falling edge of the digital signal, further comprising:
delaying the digital signal;
comparing the delayed digital signal with the digital signal to identify the first transition;
sampling the base current level of the digital signal by sampling a current level of the delayed digital signal after the first transition has been identified; and
stopping sampling of the current level of the delayed digital signal when a second transition has been identified, the second transition corresponding to a rising edge of the digital signal.
